# EUROPEAN PATENT APPLICATION

(11) **EP 4 474 904 A2**
(43) Date of publication of application: **11.12.2024**
(21) Application number: 24178169.9
(22) Date of filing: 27.05.2024
(51) Int. Cl.: G03F 1/24, G03F 1/48, G03F 1/58, G03F 1/80

(54) **REFLECTIVE PHOTOMASK BLANK WITH A ONE-LAYER OR TWO-LAYER HARD MASK AND METHOD FOR MANUFACTURING A REFLECTIVE PHOTOMASK BY DRY ETCHING THE REFLECTIVE PHOTOMASK BLANK**

(30) Priority: 06.06.2023 JP 2023092797
(71) Applicant: Shin-Etsu Chemical Co., Ltd., Tokyo 100-0005 (JP)
(72) Inventor: SAKURAI, Keisuke, Niigata 942-8601 (JP)
(74) Representative: Hindles Limited

(57) **Abstract**

A reflective photomask blank has a substrate 1; a multilayer reflective film 2 formed on the substrate and reflecting exposure light that is extreme ultraviolet region light; a protective film 3 formed on the multilayer reflective film 2 and protecting the multilayer reflective film 2; a light absorbing film 4 formed on the protective film and absorbing the exposure light; and a hard mask film provided on the light absorbing film 4. The light absorbing film 4 includes a multilayer including an absorbing layer 42 and an oxide layer 41 containing oxygen. The hard mask film includes a second layer 52, 53 or a multilayer film including a second layer 52, 53 and a first layer 51. The second layer 52, 53 includes a multilayer including an upper hard mask layer 52 and a lower hard mask layer 53 containing oxygen.

## Description

### BACKGROUND

### Technical Field

The present invention relates to a method for manufacturing a reflective photomask used for manufacturing a semiconductor device or the like, and a reflective photomask blank used for manufacturing the same as a material of the reflective photomask.

### Background Art

In accordance with miniaturization of semiconductor devices, in particular, due to high integration of large-scale integrated circuits, high pattern resolution is required for projection exposure. Therefore, in a photomask, a phase shift mask has been developed as a method for improving resolution of a transfer pattern. The principle of a phase shift method is that a phase of transmitted light that has passed through an opening of a phase shift film of a photomask is adjusted to be inverted by about 180 degrees with respect to the phase of the transmitted light that has passed through a part of the phase shift film adjacent to the opening, such that the transmitted light interferes at a boundary part between the opening and the part adjacent to the opening to decrease the light intensity, and as a result, the resolution and focal depth of the transfer pattern are improved, and the photomask using this principle is generally called a phase shift mask.

The most common phase shift mask blank as a material of a phase shift mask used for manufacturing a phase shift mask has a structure in which a phase shift film is laminated on a transparent substrate such as a glass substrate and a film formed of a material containing chromium (Cr) is laminated on the phase shift film. The phase shift film usually has a phase difference of 175 to 185 degrees and a transmittance of about 6 to 30% with respect to exposure light, and is mainly a film containing silicon (Si), and particularly a film formed of a material containing molybdenum (Mo) and silicon (Si). In addition, a film formed of a material containing chromium is adjusted to have a thickness that provides a desired optical density together with the phase shift film, and the film formed of a material containing chromium is generally used as a light shielding film and a hard mask layer when the phase shift film is etched.

As a method for manufacturing a phase shift mask by patterning a phase shift film from a phase shift mask blank in which a phase shift film formed of a material containing silicon and a light shielding film formed of a material containing chromium are formed in this order on a transparent substrate, specifically, the following method is common. First, a resist film is formed on a light shielding film that is formed of a material containing chromium of a phase shift mask blank, and a pattern is drawn and developed on the resist film with light or an electron beam to form a resist pattern. Next, using the resist pattern as an etching mask, the light shielding film formed of a material containing chromium is etched using chlorine-based gas to form a pattern of the light shielding film. Furthermore, using the pattern of the light shielding film as an etching mask, a phase shift film formed of a material containing silicon is etched using fluorine-based gas to form a pattern of the phase shift film, and then the resist pattern is removed, and the pattern of the light shielding film is etched and removed using chlorine-based gas.

In this case, the light shielding film is left outside a part where the pattern (circuit pattern) of the phase shift film is formed, and an outer peripheral edge of the phase shift mask is set as a light shielding part (light shielding pattern) having a total optical density of the phase shift film and the light shielding film of 3 or more. This is to prevent the exposure light from leaking from the outer peripheral edge of the phase shift mask and irradiating the resist film on an adjacent chip of a wafer with the exposure light from a part located outside the circuit pattern when the circuit pattern is transferred to the wafer using a wafer exposure apparatus. As a method for forming such a light shielding pattern, a method of forming a pattern of a phase shift film, removing a resist pattern, forming a new resist film, forming a resist pattern in which a resist film is left on an outer peripheral edge of a phase shift mask by pattern writing and development, and etching a film formed of a material containing chromium using the resist pattern as an etching mask to leave a light shielding film on the outer peripheral edge of the phase shift mask is generally used.

In a phase shift mask requiring high-precision pattern formation, dry etching using gas plasma is mainly used for etching. Dry etching using chlorine-based gas (chlorine-based dry etching) is used for dry etching of a film formed of a material containing chromium, and dry etching using fluorine-based gas (fluorine-based dry etching) is used for dry etching of a film containing silicon or a film containing molybdenum and silicon. In particular, in dry etching of a film formed of a material containing chromium, it is known that chemical reactivity is increased and an etching rate is improved by using etching gas obtained by mixing 10 to 25 vol% of oxygen gas (O₂ gas) with respect to chlorine gas (Cl₂ gas) as etching gas.

In accordance with miniaturization of a circuit pattern, a technique for finely forming a circuit pattern of a phase shift mask is also required. In particular, an assist pattern of a line pattern that assists resolution of a main pattern of the phase shift mask needs to be formed smaller than the main pattern so as not to be transferred to the wafer when the circuit pattern is transferred to the wafer using the wafer exposure apparatus. In the phase shift mask of the generation in which the half pitch of the line and space pattern of the circuit on the wafer is 10 nm, a line width of the assist pattern of the line pattern of the circuit on the phase shift mask is required to be about 40 nm.

A chemically amplified resist capable of forming a fine pattern contains a base resin, an acid generator, a surfactant, and the like, and since a lot of reactions in which an acid generated by exposure acts as a catalyst can be applied, high sensitivity can be achieved, and a mask pattern such as a pattern of a fine phase shift film having a line width of 0.1 um or less can be formed by using the chemically amplified resist. The resist is applied onto the photomask blank by spin coating with a resist coater.

A thickness of the resist film used for the phase shift mask blank of the tip end product is 100 to 150 nm. The reason why it is difficult to form a finer assist pattern in the phase shift mask is that since an aspect ratio of the resist pattern for forming the assist pattern formed on the light shielding film formed of a material containing chromium is high, the resist pattern falls down due to an impact by a developer or an impact by pure water during a rinsing process in the development process of forming the resist pattern.

Therefore, it has been considered to reduce the aspect ratio of the resist pattern in order to reduce the influence of the impact by the developer or the impact by the pure water. In this case, the resist film is thinned. However, in a case where the resist film is thinned, when the resist film disappears during dry etching of the light shielding film formed of the material containing chromium, pinhole defects are formed in the light shielding film formed of the material containing chromium, and when the phase shift film is dry-etched using the light shielding film formed of the material containing chromium as an etching mask, plasma during etching of the phase shift film reaches the phase shift film through the pinholes, and pinhole defects are also formed in the phase shift film, such that a normal phase shift mask cannot be manufactured.

Therefore, in order to solve the problem, a hard mask layer formed of a material containing silicon but no chromium is further provided on the light shielding film formed of a material containing chromium. In this case, the hard mask layer formed of the material containing silicon but no chromium is a thin film having a thickness of 5 to 15 nm, and a thickness of the resist layer formed on the hard mask layer is as thin as 80 to 110 nm.

When the light shielding film formed of the material containing chromium is dry-etched using chlorine-based gas containing oxygen, it is required to perform 100 to 300% over-etching of clear time in addition to clear time at which the light shielding film formed of the material containing chromium disappears. This is because chlorine-based dry etching containing oxygen is isotropic etching in which a chemical component is dominant, and a pattern of a light shielding film formed of a material containing chromium is insufficiently etched at a boundary part with the phase shift film to form a trail shape, such that a desired pattern width is not stably formed.

In addition, since the etching is isotropic etching in which a chemical component is dominant, chlorine-based plasma containing oxygen moves in a vertical direction and a horizontal direction with respect to the substrate, and causes side etching in the pattern of the light shielding film formed of the material containing chromium, and in order to make a critical dimension (CD), which is a pattern line width, uniform over the entire surface of the mask, it is required to obtain the same side etching amount over the entire surface of the mask. To this end, long-time dry etching is required until the amount of side etching is stabilized by causing saturation.

On the other hand, when the phase shift film formed of the material containing silicon is dry-etched using the fluorine-based gas, about 20% over-etching (for example, short over-etching for 1 to 6 seconds) of clear time at the maximum is performed in addition to the clear time at which the phase shift film formed of the material containing silicon disappears, and the transparent substrate in contact with the phase shift film is also slightly etched by dry etching to adjust a phase difference to 175 to 185 degrees with respect to exposure light. In this case, a phase shift film formed of a material containing silicon generally has an initial phase difference set to 175 to 179 degrees, and a desired phase difference, that is, 175 to 185 degrees by digging the transparent substrate by over-etching.

The reason why the over-etching may be performed in a short time in the fluorine-based dry etching is that the fluorine-based dry etching is anisotropic etching in which a physical component is dominant, the pattern of the phase shift film formed of the material containing silicon does not have a trail shape at the boundary part with the substrate, the fluorine-based plasma moves in the vertical direction with respect to the substrate surface, and the CD of the light shielding film formed of the material containing chromium that functions as an etching mask is faithfully reproduced, and thus, the long-time over-etching is not required.

Since fluorine-based dry etching is anisotropic etching in which a physical component is dominant, the amount of resist disappeared is generally larger than that in chlorine-based dry etching containing oxygen. Therefore, a resist film for forming a pattern of a hard mask layer formed of a material containing silicon needs to have a corresponding thickness. However, since the hard mask layer formed of the material containing silicon serves as an etching mask when the light shielding film formed of the material containing chromium is dry-etched using the chlorine-based gas, and has sufficient etching resistance to the chlorine-based gas, the hard mask layer formed of the material containing silicon can be thinned. When the hard mask layer formed of the material containing silicon is thin, the time for fluorine-based dry etching on the hard mask layer is shortened, and as a result, the resist film required to form the pattern of the hard mask layer formed of the material containing silicon can also be thinned. For this reason, a resist film used for etching of the hard mask layer, that is, a resist film first used for a phase shift mask blank can be thinned by using a hard mask layer formed of a material containing silicon. Then, since the aspect ratio of the resist pattern is reduced by thinning the resist film, the influence of a physical impact when applying a developer in the development process of forming the resist pattern or a physical impact when applying pure water in a rinsing process is reduced, an excellent assist pattern can be formed, and high resolution of the transfer pattern can be realized.

As a method for manufacturing a phase shift mask by patterning a phase shift film from a phase shift mask blank in which a phase shift film formed of a material containing silicon, a light shielding film formed of a material containing chromium, and a hard mask layer formed of a material containing silicon are formed in this order on a transparent substrate, specifically, the following method is common. First, a resist film is formed on a hard mask layer, and a pattern is drawn and developed on the resist film with light or an electron beam to form a resist pattern. Next, using the resist pattern as an etching mask, a hard mask layer formed of a material containing silicon is dry-etched using fluorine-based gas to form a pattern of the hard mask layer, and then the resist pattern is removed. Next, using the pattern of the hard mask layer as an etching mask, the light shielding film formed of a material containing chromium is dry-etched using chlorine-based gas to form a pattern of the light shielding film. Furthermore, using the pattern of the light shielding film as an etching mask, a phase shift film formed of a material containing silicon is dry-etched using fluorine-based gas to form a pattern of the phase shift film and simultaneously to remove the pattern of the hard mask layer, and then the pattern of the light shielding film is etched and removed using chlorine-based gas.

Furthermore, in recent years, higher pattern resolution has been required for projection exposure, but even with phase shift masks, it is no longer possible to obtain the desired pattern resolution. Therefore, EUV lithography using extreme ultraviolet region light for exposure light has been used.

The extreme ultraviolet region light is easily absorbed by any substance, and transmission lithography such as photolithography using ArF excimer laser light of the related art cannot be used. Therefore, in the EUV lithography, a reflection optical system is used. Since a wavelength of the extreme ultraviolet region light used in the EUV lithography is 13 to 14 nm and a wavelength of ArF excimer laser light of the related art is 193 nm, the exposure wavelength is short as compared in the photolithography using the ArF excimer laser light of the related art, and it is possible to transfer a finer pattern on the photomask.

The photomask used in the EUV lithography generally has a structure in which a reflective film that reflects extreme ultraviolet region light, a protective film that protects the reflective film, and a light absorbing film that absorbs the extreme ultraviolet region light are formed in this order on a substrate such as a glass substrate. As the reflective film, a multilayer reflective film, in which a reflectance when the surface of the reflective film is irradiated with the extreme ultraviolet region light is increased by alternately laminating a low refractive index layer and a high refractive index layer, is used. Usually, a molybdenum (Mo) layer is used as the low refractive index layer of the multilayer reflective film, and a silicon (Si) layer is used as the high refractive index layer. As the protective film, a ruthenium (Ru) film is usually used. On the other hand, a material having a high absorption coefficient for EUV light, specifically, for example, a material containing chromium (Cr) or tantalum (Ta) as a main component is used for the light absorbing film.

As a method for manufacturing a reflective photomask by patterning a light absorbing film from a reflective photomask blank in which a reflective film that reflects extreme ultraviolet region light, a protective film that protects the reflective film, and a light absorbing film that absorbs the extreme ultraviolet region light are formed in this order on a substrate, specifically, the following method is common. First, a resist film is formed on a light absorbing film, and a pattern is drawn and developed on the resist film with light or an electron beam to form a resist pattern. Next, a pattern of the light absorbing film is formed, and then the resist pattern is removed.

In the reflective photomask required in the EUV lithography, assist patterns of a line pattern and a space pattern, which assist the resolution of the main pattern, are further reduced as the main pattern is miniaturized, and a line width of the assist pattern is required to be reduced to about 30 nm, and particularly about 25 nm. Therefore, as compared with the phase shift mask blank, the reflective photomask blank requires further thinning of the resist film.

In order to form the assist patterns of the line pattern and the space pattern to about 30 nm, and particularly about 25 nm in the reflective photomask, the thickness of the resist film needs to be 80 nm or less.

Further, in the EUV lithography, in order to produce a finer pattern on a wafer, an optical system that changes a numerical aperture NA of an exposure machine from 0.33 to 0.55 is used.

In this case, in the reflective photomask, the assist patterns of the line pattern and the space pattern, which assist the resolution of the main pattern, are further reduced as the main pattern is miniaturized, and the line width of the assist pattern is required to be reduced to about 25 nm, and particularly about 20 nm. Therefore, in the reflective photomask blank used in the exposure machine with an aperture ratio of 0.55, it is required to make the resist film even thinner. In addition, it is required not only to reduce the thickness of the resist film but also to reduce deterioration of resolution due to disappearance of the fine line pattern during the dry etching process.

For example, in a case where a pattern (circuit pattern) of a light absorbing film is formed from a light absorbing film containing tantalum as a main component by fluorine-based dry etching using a resist pattern as an etching mask, fluorine-based dry etching is anisotropic etching in which a physical component is dominant, and an etching rate with respect to the resist pattern is relatively high. Therefore, when the resist pattern is too thin, the resist pattern disappears during dry etching with respect to the light absorbing film, pinhole defects are formed in the light absorbing film, and thus, a normal reflective photomask cannot be manufactured.

In order to prevent the pinhole defects, it is required to make the resist film thick. However, the thicker the resist film, the higher the aspect ratio of the resist pattern to form a finer assist pattern. Therefore, in the development process of forming a resist pattern, the resist pattern falls down due to the impact by the developer or the impact by the pure water during the rinsing process, which makes it impossible to obtain the desired resolution.

For example, WO 2012/105508 A describes a reflective mask blank for EUV lithography in which a layer that reflects EUV light, an absorbing layer that absorbs EUV light, and a hard mask layer are formed in this order on a substrate. In this case, it is described that when the absorbing layer is a layer containing at least one of tantalum (Ta) and palladium (Pd) as a main component, and the hard mask layer is a layer containing chromium (Cr), nitrogen (N) or oxygen (O), and hydrogen (H) and having a total content of Cr, N or Cr, and O of 85 of 99.9 at% and a content of H of 0.1 to 15 at%, surface roughness of the hard mask layer is small, an etching selection ratio under the etching conditions of the absorbing layer is sufficiently high, a crystalline state becomes amorphous, and the surface roughness can be sufficiently reduced. Therefore, line edge roughness of the pattern of the hard mask layer and the pattern of the absorbing layer formed using the pattern of the hard mask layer does not increase, and a high-resolution pattern can be obtained.

In addition, WO 2012/105508 A describes a procedure for forming a pattern on a reflective mask blank for EUV lithography as follows. First, a resist film is formed on a hard mask layer of an EUV mask blank, and a pattern is formed on the resist film using an electron beam lithography machine. Next, using the patterned resist film as a mask, etching is performed by a chlorine-based gas process to form a pattern on the hard mask layer. Next, using the patterned hard mask layer as a mask, etching is performed by a fluorine-based gas process to form a pattern on an absorbing layer. Next, etching is performed by a chlorine-based gas process to remove the hard mask layer.

### SUMMARY OF INVENTION

### PROBLEM TO BE SOLVED BY INVENTION

In the method described in WO 2012/105508 A, for example, the absorbing layer is patterned by fluorine-based dry etching using a CrNH film or a CrOH film as a hard mask layer and a film containing tantalum as an absorbing layer. In this case, since the film (CrNH film or CrOH film) formed of the material containing chromium has high resistance to fluorine-based dry etching and thus has a low etching rate, and the film containing tantalum as a main component has low resistance to fluorine-based dry etching and thus has a high etching rate, the hard mask layer can be thinned. On the other hand, the film containing tantalum is patterned by chlorine-based dry etching, but as the hard mask layer becomes thinner, a reduction amount of the resist film during dry etching also decreases, such that the resist film formed on the hard mask layer can be thinned. As a result, the aspect ratio of the resist pattern is reduced, and the impact by the developer during the development process of resist pattern formation or the impact by the pure water during the rinsing process is reduced, such that the hard mask layer provides an excellent assist pattern.

However, as described above, when the hard mask layer formed of the material containing chromium is dry-etched using chlorine-based gas containing oxygen, it is required to perform 100 to 300% over-etching of clear time in addition to clear time at which the hard mask layer formed of the material containing chromium disappears, and therefore, in this case, it is not possible to reduce the thickness of the resist film to 80 nm or less.

In addition, in general, a film formed of a material containing chromium has resistance to chlorine-based dry etching containing no oxygen and fluorine-based dry etching, and can be removed by chlorine-based dry etching containing oxygen. Therefore, when a hard mask layer formed of a material containing chromium is peeled off by dry etching using chlorine-based gas containing oxygen after the light absorbing film is patterned, a protective film that protects the multilayer reflective film is exposed to oxygen and chlorine plasma. A ruthenium-based material generally used for a protective film has low resistance to chlorine-based dry etching containing oxygen, and may disappear during peeling of the hard mask layer formed of the material containing chromium, and a process window of a dry etching process using chlorine-based gas containing oxygen is narrowed. In addition, in a case where a thickness of the protective film is reduced by chlorine-based dry etching containing oxygen, there is a risk that the reflective multilayer film is exposed due to the reduction of the protective film by the subsequent cleaning process (sulfuric acid cleaning), and thus, the reflective multilayer film is damaged and the reflectance performance is deteriorated.

In addition, when the hard mask layer formed of a material containing chromium is patterned by dry etching using chlorine-based gas containing oxygen, side etching easily occurs, and a fine line pattern easily disappears, resulting in deterioration of resolution of the line pattern.

The present invention has been made to solve the above problems, and a first object of the present invention is to provide a reflective photomask blank capable of preferably forming an assist pattern having a line width of about 25 nm, and particularly about 20 nm, when a reflective photomask is manufactured from a reflective photomask blank including a multilayer reflective film that reflects exposure light that is extreme ultraviolet region light, a protective film that protects the multilayer reflective film, and a light absorbing film that absorbs the exposure light on a substrate, and specifically, a reflective photomask blank capable of preferably forming an assist pattern having a line width of about 25 nm, and particularly about 20 nm, even when a resist film is thin, for example, even when a resist film has a thickness of 60 nm or less, and capable of minimizing a decrease in thickness of a protective film after completion of all dry etching processes. Further, a second object of the present invention is to provide a method for manufacturing a reflective photomask blank from such a reflective photomask blank.

### MEANS FOR SOLVING PROBLEM

As described above, the reflective photomask blank of the related art has a problem that a resist film having a thickness of 60 nm or less does not remain after dry etching, and a fine assist pattern cannot be preferably formed.

Therefore, as a result of intensive studies to solve the above problems, the present inventors have found that, on a light absorbing film of a reflective photomask blank including a multilayer reflective film reflecting exposure light that is extreme ultraviolet region light, a protective film protecting the multilayer reflective film, and a light absorbing film absorbing the exposure light, a first layer and a second layer that are in contact with the light absorbing film and function as hard masks when the light absorbing film is patterned by dry etching are provided,
the light absorbing film is a multilayer including an oxide layer of the light absorbing film containing oxygen and an absorbing layer containing a small amount of oxygen even when oxygen is contained, the oxide layer of the light absorbing film is formed of a material that has resistance to chlorine-based dry etching and can be removed by fluorine-based dry etching, the absorbing layer of the light absorbing film is formed of a material that has resistance to chlorine-based dry etching containing oxygen and can be removed by chlorine-based dry etching containing no oxygen and fluorine-based dry etching,
the first layer is formed of a material that has resistance to chlorine-based dry etching and can be removed by fluorine-based dry etching, the second layer is a multilayer including an upper hard mask layer 2A of the second layer, the upper hard mask layer 2A containing oxygen and being provided on a side that is spaced from the substrate, and a lower hard mask layer 2B of the second layer, the upper hard mask layer 2A of the second layer is formed of a material that has resistance to chlorine-based dry etching and can be removed by fluorine-based dry etching, the lower hard mask layer 2B of the second layer is formed of a material that has resistance to chlorine-based dry etching containing oxygen and can be removed by chlorine-based dry etching containing no oxygen and fluorine-based dry etching, and a total etching clear time when the first layer and the upper hard mask layer 2A of the second layer are subjected to fluorine-based dry etching is set to be shorter than a total etching clear time when 1/2 of a thickness of the oxide layer of the light absorbing film and the absorbing layer of the light absorbing film is subjected to etching under the same fluorine-based dry etching conditions, such that the problems described above could be solved, thereby completing the present invention.

Therefore, the present invention provides the following reflective photomask blank and method for manufacturing a reflective photomask.

A reflective photomask blank may comprise:
a substrate;
a multilayer reflective film formed on the substrate and reflecting exposure light that is extreme ultraviolet region light;
a protective film formed on the multilayer reflective film and protecting the multilayer reflective film;
a light absorbing film formed on the protective film and absorbing the exposure light; and
a hard mask film provided on the light absorbing film,
wherein the light absorbing film may include a multilayer including an absorbing layer and an oxide layer containing oxygen and provided on a side that is spaced from the substrate,
wherein the oxide layer of the light absorbing film may be formed of a material that has resistance to chlorine-based dry etching and is removable by fluorine-based dry etching,
wherein the absorbing layer of the light absorbing film may be formed of a material that has resistance to chlorine-based dry etching containing oxygen and is removable by chlorine-based dry etching containing no oxygen and fluorine-based dry etching,
wherein the hard mask film may include a second layer or a multilayer film including a second layer and a first layer formed on a side of the second layer that is spaced from the substrate,
wherein in a case where the first layer is included, the first layer may be formed of a material that has resistance to chlorine-based dry etching and is removable by fluorine-based dry etching,
wherein the second layer may include a multilayer including an upper hard mask layer provided on a side that is spaced from the substrate and containing oxygen, and a lower hard mask layer of the second layer,
wherein the upper hard mask layer of the second layer may be formed of a material that has resistance to chlorine-based dry etching and is removable by fluorine-based dry etching, and
wherein the lower hard mask layer of the second layer may be formed of a material that has resistance to chlorine-based dry etching containing oxygen and is removable by chlorine-based dry etching containing no oxygen and fluorine-based dry etching,
wherein in a case where the first layer is not included, etching clear time when the upper hard mask layer of the second layer is subjected to fluorine-based dry etching under one condition may be shorter than etching clear time when 1/2 of a thickness of the absorbing layer of the light absorbing film is subjected to the fluorine-based dry etching under the one condition, and
wherein in a case where the first layer is included, a total of etching clear time when the first layer is subjected to fluorine-based dry etching under one condition and etching clear time when the upper hard mask layer of the second layer is subjected to the fluorine-based dry etching under the one condition may be shorter than a total of etching clear time when the oxide layer of the light absorbing film is subjected to the fluorine-based dry etching under the one condition and the etching clear time when 1/2 of the thickness of the absorbing layer of the light absorbing film is subjected to the fluorine-based dry etching under the one condition.

A method for manufacturing, from the reflective photomask blank according to any one of concepts 1 to 10, a reflective photomask including an oxide layer pattern of the light absorbing film and an absorbing layer pattern of the light absorbing film, the method may comprise:
(A) forming a resist film in contact with a side of the first layer that is spaced from the substrate;
(B) patterning the resist film to form a resist pattern;
(C) using the resist pattern as an etching mask, simultaneously patterning the first layer and the upper hard mask layer of the second layer by dry etching using fluorine-based gas to simultaneously form a first layer pattern and an upper hard mask layer pattern of the second layer;
(D) removing the resist pattern;
(E) using the first layer pattern and the upper hard mask layer pattern of the second layer as etching masks, patterning the lower hard mask layer of the second layer by dry etching using chlorine-based gas containing no oxygen to form a lower hard mask layer pattern of the second layer;
(F) using the first layer pattern, the upper hard mask layer pattern of the second layer, and the lower hard mask layer pattern of the second layer as etching masks, patterning the oxide layer of the light absorbing film and partially patterning the absorbing layer of the light absorbing film by dry etching using fluorine-based gas to form the oxide layer pattern of the light absorbing film and to partially form the absorbing layer pattern of the light absorbing film, and simultaneously to remove the first layer pattern and the upper hard mask layer pattern of the second layer and to partially remove the lower hard mask layer pattern of the second layer; and
(G) using remaining parts of the lower hard mask layer pattern of the second layer as an etching mask, patterning the absorbing layer of the light absorbing film by dry etching using chlorine-based gas containing no oxygen, and partially removing the lower hard mask layer pattern of the second layer, simultaneously.

### EFFECT OF INVENTION

According to the present invention, a fine assist pattern can be preferably formed.

According to one aspect of the present invention, a thickness of a resist film can be reduced, and an assist pattern having a line width of about 25 nm, and particularly about 20 nm can be preferably formed by reducing an aspect ratio of a resist pattern.

In general, when a hard mask layer formed of a material containing chromium is used, chlorine-based dry etching containing oxygen needs to be performed. Chlorine-based dry etching containing oxygen has a large isotropic etching component in which a chemical component is dominant, and causes side etching on a side wall of a chromium pattern, and thus, the pattern is broken and pattern disappearance occurs during etching.

On the other hand, in the present invention, since chlorine-based dry etching containing no oxygen can be used for the lower hard mask layer 2B of the second layer as an example, the isotropic etching component is smaller than that in chlorine-based dry etching containing oxygen, side etching does not occur on the side wall of the lower hard mask layer 2B of the second layer, and pattern disappearance during etching does not occur. Therefore, high resolution is obtained in the transfer pattern of the reflective photomask manufactured from the reflective photomask blank. Here, the lower hard mask layer 2B of the second layer is a material containing no chromium.

In addition, when the reflective photomask is manufactured from the reflective photomask blank, the absorbing layer of the light absorbing film is patterned, and at the same time, when the lower hard mask layer pattern of the second layer is removed, chlorine-based dry etching containing no oxygen can be performed, and damage to the protective film can be reduced. As a result, a reflective photomask having a wide process window and high cleaning resistance can be obtained.

### BRIEF DESCRIPTION OF DRAWINGS

FIG. 1 is a cross-sectional view showing an example of a first aspect of a reflective photomask blank of the present invention;
FIG. 2 is a cross-sectional view showing an example of a second aspect of a reflective photomask blank of the present invention;
FIG. 3 is a cross-sectional view showing an example of a reflective photomask of the present invention;
FIG. 4A is a cross-sectional view for explaining a process of manufacturing a reflective photomask from the reflective photomask blank according to the first aspect of the present invention;
FIG. 4B is a cross-sectional view following FIG. 4A for explaining the process of manufacturing the reflective photomask from the reflective photomask blank according to the first aspect of the present invention;
FIG. 4C is a cross-sectional view following FIG. 4B for explaining the process of manufacturing the reflective photomask from the reflective photomask blank according to the first aspect of the present invention;
FIG. 4D is a cross-sectional view following FIG. 4C for explaining the process of manufacturing the reflective photomask from the reflective photomask blank according to the first aspect of the present invention;
FIG. 4E is a cross-sectional view following FIG. 4D for explaining the process of manufacturing the reflective photomask from the reflective photomask blank according to the first aspect of the present invention;
FIG. 4F is a cross-sectional view following FIG. 4E for explaining the process of manufacturing the reflective photomask from the reflective photomask blank according to the first aspect of the present invention;
FIG. 4G is a cross-sectional view following FIG. 4F for explaining the process of manufacturing the reflective photomask from the reflective photomask blank according to the first aspect of the present invention;
FIG. 5 is a cross-sectional view showing an example of a third aspect of a reflective photomask blank of the present invention;
FIG. 6A is a cross-sectional view for explaining a process of manufacturing a reflective photomask from the reflective photomask blank according to the third aspect of the present invention;
FIG. 6B is a cross-sectional view following FIG. 6A for explaining the process of manufacturing the reflective photomask from the reflective photomask blank according to the third aspect of the present invention;
FIG. 6C is a cross-sectional view following FIG. 6B for explaining the process of manufacturing the reflective photomask from the reflective photomask blank according to the third aspect of the present invention;
FIG. 6D is a cross-sectional view following FIG. 6C for explaining the process of manufacturing the reflective photomask from the reflective photomask blank according to the third aspect of the present invention;
FIG. 6E is a cross-sectional view following FIG. 6D for explaining the process of manufacturing the reflective photomask from the reflective photomask blank according to the third aspect of the present invention;
FIG. 6F is a cross-sectional view following FIG. 6E for explaining the process of manufacturing the reflective photomask from the reflective photomask blank according to the third aspect of the present invention; and
FIG. 6G is a cross-sectional view following FIG. 6F for explaining the process of manufacturing the reflective photomask from the reflective photomask blank according to the third aspect of the present invention.

### DETAILED DESCRIPTION

Hereinafter, the present invention will be described in more detail.

A reflective photomask blank of the present invention may have a substrate, a multilayer reflective film formed on the substrate and reflecting exposure light that is extreme ultraviolet region light, a protective film formed on the multilayer reflective film and protecting the multilayer reflective film, a light absorbing film formed on the protective film and absorbing the exposure light that is extreme ultraviolet region light, and a first layer, an upper hard mask layer 2A of a second layer, and a lower hard mask layer 2B of the second layer that are formed on the light absorbing film so as to be in contact with the light absorbing film and function as hard masks when the light absorbing film is patterned by dry etching. The hard mask may be a film (laminated film) including a multilayer including a first layer and a second layer provided on a side farthest from the substrate. The second layer may have an upper hard mask layer 2A containing oxygen on a surface layer. In addition, the light absorbing film may have an oxide film containing oxygen on a surface layer.

A reflective photomask blank according to another aspect of the present invention may have a substrate, a multilayer reflective film formed on the substrate and reflecting exposure light that is extreme ultraviolet region light, a protective film formed on the multilayer reflective film and protecting the multilayer reflective film, a light absorbing film formed on the protective film and absorbing the exposure light that is extreme ultraviolet region light, and an upper hard mask layer 2A of a second layer and a lower hard mask layer 2B of the second layer that are formed on the light absorbing film so as to be in contact with the light absorbing film and function as hard masks when the light absorbing film is patterned by dry etching, without the above first layer. The second layer of the hard mask may be a film (laminated film) including a multilayer. The second layer may have an upper hard mask layer 2A containing oxygen on a surface layer. In addition, the light absorbing film may have an oxide film containing oxygen on a surface layer.

The reflective photomask blank of the present invention may further include a resist film.

From the reflective photomask blank, for example, it is possible to obtain a reflective photomask including a substrate, a multilayer reflective film formed on the substrate and reflecting exposure light that is extreme ultraviolet region light, a protective film formed on the multilayer reflective film and protecting the multilayer reflective film, and a pattern (circuit pattern or photomask pattern) of a light absorbing film that is formed on the protective film and absorbs the exposure light that is extreme ultraviolet region light.

Hereinafter, structures of the reflective photomask blank and the reflective photomask of the present invention will be described with reference to the drawings. In the description of the drawings, the same components are denoted by the same reference numerals, and the description thereof may be omitted. In addition, the drawings may be shown enlarged for convenience, and a dimensional ratio of each component is not necessarily the same as actual one.

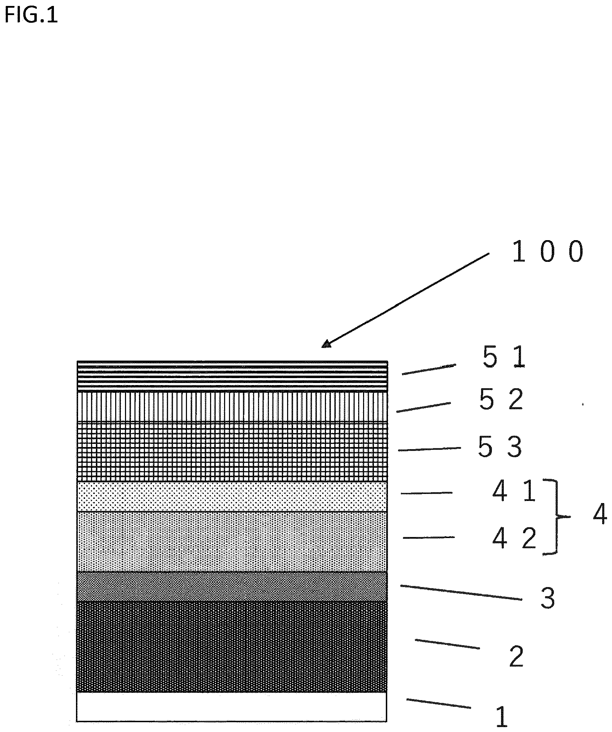

FIG. 1 is a cross-sectional view showing an example of a first aspect of a reflective photomask blank of the present invention. A reflective photomask blank 100 has a substrate 1, a multilayer reflective film 2 formed on the substrate 1 so as to be in contact with the substrate 1 and reflecting exposure light that is extreme ultraviolet region light, a protective film 3 formed on the multilayer reflective film 2 so as to be in contact with the multilayer reflective film 2 and protecting the multilayer reflective film 2, a light absorbing film 4 formed on the protective film 3 so as to be in contact with the protective film 3 and absorbing the exposure light, and a first layer 51, an upper hard mask layer 2A of a second layer (hereinafter, also referred to as an "upper hard mask layer 52"), and a lower hard mask layer 2B of the second layer (hereinafter, also referred to as a "lower hard mask layer 53") that are formed on the light absorbing film 4 so as to be in contact with the light absorbing film 4 and function as hard masks when the light absorbing film 4 is patterned by dry etching.

The light absorbing film 4 may have an oxide layer 41 of the light absorbing film provided on a side that is spaced from the substrate, and an absorbing layer 42 of the light absorbing film for absorbing light.

In other words, in the reflective photomask blank 100, the multilayer reflective film 2, the protective film 3, the absorbing layer 42 of the light absorbing film, the oxide layer 41 of the light absorbing film, the lower hard mask layer 53 of the second layer, the upper hard mask layer 52 of the second layer, and the first layer 51 are laminated in this order from the substrate 1.

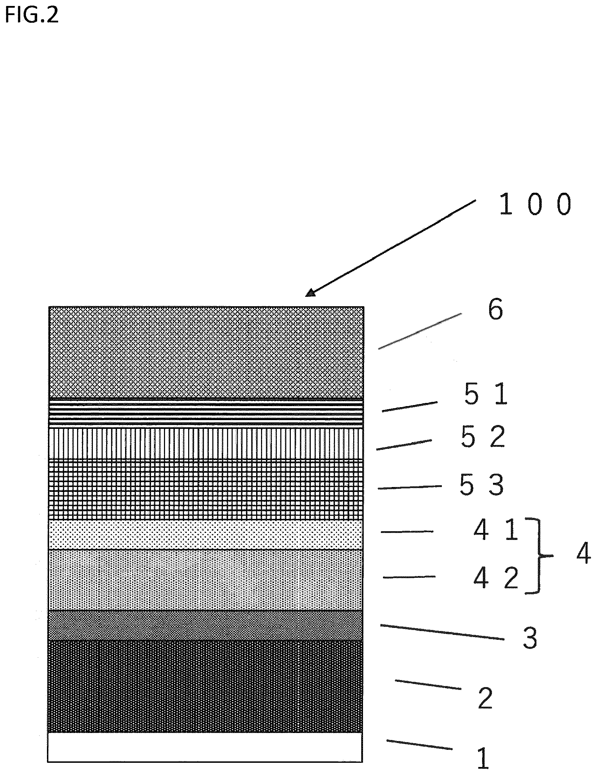

FIG. 2 is a cross-sectional view showing an example of a second aspect of a reflective photomask blank of the present invention. The reflective photomask blank 100 has a substrate 1, a multilayer reflective film 2 formed on the substrate 1 so as to be in contact with the substrate 1 and reflecting exposure light that is extreme ultraviolet region light, a protective film 3 formed on the multilayer reflective film 2 so as to be in contact with the multilayer reflective film 2 and protecting the multilayer reflective film 2, a light absorbing film 4 formed on the protective film 3 so as to be in contact with the protective film 3 and absorbing the exposure light, and a first layer 51, an upper hard mask layer 52 of a second layer, and a lower hard mask layer 53 of the second layer that are formed on the light absorbing film 4 so as to be in contact with the light absorbing film 4 and function as hard masks when the light absorbing film 4 is patterned by dry etching. Furthermore, a resist film 6 is provided on the first layer 51. The light absorbing film 4 has an oxide layer 41 of the light absorbing film provided on a side that is spaced from the substrate, and an absorbing layer 42 of the light absorbing film for absorbing light.

In other words, in the reflective photomask blank 100, the multilayer reflective film 2, the protective film 3, the absorbing layer 42 of the light absorbing film, the oxide layer 41 of the light absorbing film, the lower hard mask layer 53 of the second layer, the upper hard mask layer 52 of the second layer, the first layer 51, and the resist film 6 are laminated in this order from the substrate 1.

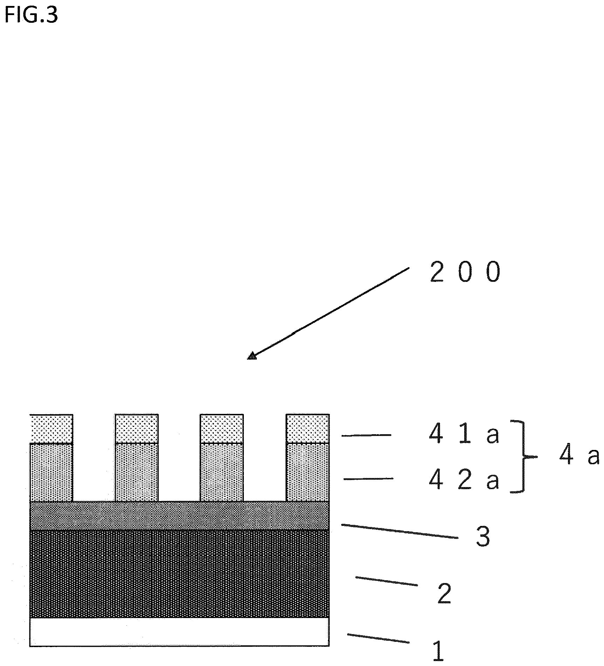

FIG. 3 is a cross-sectional view showing an example of a reflective photomask 200 of the present invention. The reflective photomask includes a substrate 1, a multilayer reflective film 2 formed on the substrate 1 so as to be in contact with the substrate 1 and reflecting exposure light that is extreme ultraviolet region light, a protective film 3 formed on the multilayer reflective film 2 so as to be in contact with the multilayer reflective film 2 and protecting the multilayer reflective film, and a light absorbing film pattern (a circuit pattern or a photomask pattern) 4a formed on the protective film 3 so as to be in contact with the protective film 3 and absorbing exposure light, and the light absorbing film pattern 4a includes an oxide layer pattern 41a of the light absorbing film and an absorbing layer pattern 42a of the light absorbing film. In other words, in the reflective photomask 200, the multilayer reflective film 2, the protective film 3, and the light absorbing film pattern 4a are laminated in this order from the substrate 1. The light absorbing film pattern 4a includes an oxide layer pattern 41a of the light absorbing film and an absorbing layer pattern 42a of the light absorbing film.

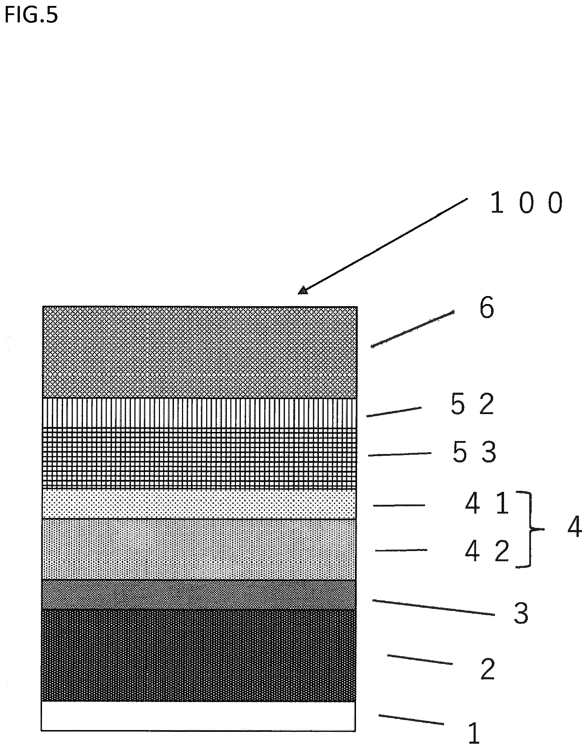

FIG. 5 is a cross-sectional view showing an example of a third aspect of a reflective photomask blank of the present invention. The reflective photomask blank 100 includes a substrate 1, a multilayer reflective film 2 formed on the substrate 1 so as to be in contact with the substrate 1 and reflecting exposure light that is extreme ultraviolet region light, a protective film 3 formed on the multilayer reflective film 2 so as to be in contact with the multilayer reflective film 2 and protecting the multilayer reflective film 2, a light absorbing film 4 formed on the protective film 3 so as to be in contact with the protective film 3 and absorbing the exposure light, and an upper hard mask layer 52 of a second layer and a lower hard mask layer 53 of the second layer that are formed on the light absorbing film 4 so as to be in contact with the light absorbing film 4 and function as hard masks when the light absorbing film 4 is patterned by dry etching. In this case, the light absorbing film 4 has an oxide layer 41 of the light absorbing film provided on a side that is spaced from the substrate, and an absorbing layer 42 of the light absorbing film for absorbing light.

In other words, in the reflective photomask blank 100, the multilayer reflective film 2, the protective film 3, the absorbing layer 42 of the light absorbing film, the oxide layer 41 of the light absorbing film, the lower hard mask layer 53 of the second layer, the upper hard mask layer 52 of the second layer, and the resist film 6 are laminated in this order from the substrate 1.

### Substrate

The type and size of the substrate are not particularly limited, and the substrates of the reflective photomask blank and the reflective photomask may or may not be transparent at an exposure wavelength. As the substrate, for example, a glass substrate such as a quartz substrate can be used. In addition, as the substrate, for example, a so-called 6025 substrate having a size of 6 inch square and a thickness of 0.25 inches defined in the SEMI standard is preferable. When SI units are used, the 6025 substrate is usually described as a substrate having a size of 152 mm square and a thickness of 6.35 mm. In addition, when the reflective mask is held on a mask stage of an exposure apparatus, the reflective mask is fixed by an electrostatic chuck. Therefore, a back surface film may be formed on a back surface of the substrate (a surface opposite to a surface on which the multilayer reflective film or the like is formed) in order to promote fixing of the substrate by the electrostatic chuck.

### Multilayer Reflective Film

The multilayer reflective film is a film that reflects exposure light that is extreme ultraviolet region light. The multilayer reflective film is preferably formed in contact with the substrate. The extreme ultraviolet region light is called EUV light, a wavelength of the EUV light is 13 to 14 nm, and the EUV light is usually light having a wavelength of about 13.5 nm. A material constituting the multilayer reflective film is preferably a material that has resistance to dry etching (chlorine-based dry etching) using chlorine-based gas (for example, only Cl₂ gas or mixed gas of Cl₂ gas and O₂ gas) and can be removed by dry etching (fluorine-based dry etching) using fluorine-based gas (for example, CF₄ gas or SF₆ gas) . Specific examples of the material constituting the multilayer reflective film include molybdenum (Mo) and silicon (Si). As the multilayer reflective film, a laminated film (Si/Mo laminated film) in which about 20 to 60 layers of a molybdenum (Mo) layer and a silicon (Si) layer are alternately laminated is generally used. A thickness of the multilayer reflective film is preferably 200 nm or more and particularly 220 nm or more, and is preferably 340 nm or less and particularly 280 nm or less. A thickness of the molybdenum (Mo) layer is preferably 1 nm or more and particularly 2 nm or more, and is preferably 5 nm or less and particularly 4 nm or less. A thickness of the silicon (Si) layer is preferably 2 nm or more and particularly 3 nm or more, and is preferably 6 nm or less and particularly 5 nm or less.

### Protective Film

The protective film is a film for protecting the multilayer reflective film. The protective film is preferably formed in contact with the multilayer reflective film. The protective film is provided to protect the multilayer reflective film, for example, in cleaning in processing into the reflective photomask, correction of the reflective photomask, or the like. In addition, the protective film preferably has a function of protecting the multilayer reflective film when the light absorbing film is patterned by etching and preventing oxidation of the multilayer reflective film. A material constituting the protective film is preferably a material having an etching characteristic different from that of the light absorbing film, and specifically, is a material having resistance to chlorine-based dry etching, and is preferably a material having resistance to cleaning containing sulfuric acid and cleaning containing alkali. Specific examples of the material constituting the protective film include a material containing ruthenium (Ru). The protective film may be formed of a ruthenium compound containing one or more selected from Mo, Nb, Zr, Y, B, Ti, and La in order to have resistance to chlorine-based dry etching, chlorine-based dry etching containing oxygen, cleaning containing sulfuric acid, and cleaning containing alkali.

The protective film may be a single layer film, a multilayer film (for example, a film including 2 to 4 layers), or a film having a gradient composition. A thickness of the protective film is preferably 1 nm or more and preferably 20 nm or less.

### Absorbing Layer of Light Absorbing Film

The light absorbing film includes an oxide layer of the light absorbing film and an absorbing layer of the light absorbing film, and the absorbing layer of the light absorbing film is a film that absorbs exposure light that is extreme ultraviolet region light. The absorbing layer of the light absorbing film is preferably formed in contact with the protective film. The absorbing layer of the light absorbing film is preferably formed of a material that has resistance to chlorine-based dry etching containing oxygen and can be removed by chlorine-based dry etching containing no oxygen and fluorine-based dry etching. The absorbing layer of the light absorbing film is preferably formed of a material containing tantalum (Ta). Specific examples of the material containing tantalum in the absorbing layer of the light absorbing film include elemental tantalum (Ta) and a tantalum compound containing tantalum (Ta), and one or more selected from nitrogen (N), boron (B), and the like. Examples of such a material include a material (Ta) formed of tantalum, a material (TaN) formed of tantalum and nitrogen, a material (TaB) formed of tantalum and boron, and a material (TaNB) formed of tantalum, nitrogen, and boron. In addition, the tantalum compound may contain a trace amount of oxygen (O). The light absorbing film may be a single layer film, a multilayer film (for example, a film including 2 to 4 layers), or a film having a gradient composition. A thickness of the absorbing layer of the light absorbing film is preferably 30 nm or more, more preferably 40 nm or more, and particularly 50 nm or more, and is preferably 100 nm or less, more preferably 80 nm or less, and particularly 74 nm or less.

### Oxide Layer of Light Absorbing Film

The oxide layer of the light absorbing film is a film that reduces light reflectance. The oxide layer of the light absorbing film is preferably formed in contact with the absorbing layer of the light absorbing film.

The oxide layer of the light absorbing film is preferably formed of a material that has resistance to chlorine-based dry etching and can be removed by fluorine-based dry etching. The oxide layer of the light absorbing film is preferably formed of a material containing tantalum (Ta) and oxygen (O).

The material containing tantalum and oxygen may be a tantalum compound containing a material selected from nitrogen (N), boron (B), and the like. Examples of such a material include a material (TaO) formed of tantalum and oxygen, a material (TaON) formed of tantalum, oxygen, and nitrogen, a material (TaOB) formed of tantalum, oxygen, and boron, and a material (TaONB) formed of tantalum, oxygen, nitrogen, and boron. The oxide layer of the light absorbing film may be a single layer film, a multilayer film (for example, a film including 2 to 4 layers), or a film having a gradient composition. A thickness of the oxide layer of the light absorbing film is preferably 1 nm or more and particularly 2 nm or more, and is preferably 10 nm or less and particularly 5 nm or less, in order to reduce the light reflectance.

In order that the absorbing layer of the light absorbing film can be removed by chlorine-based dry etching containing no oxygen, an oxygen content ratio is preferably 5% or less and is particularly preferably 3% or less.

In order for the oxide layer of the light absorbing film to have resistance to chlorine-based dry etching containing no oxygen, the oxygen content ratio is preferably 15% or more and is particularly preferably 18% or more.

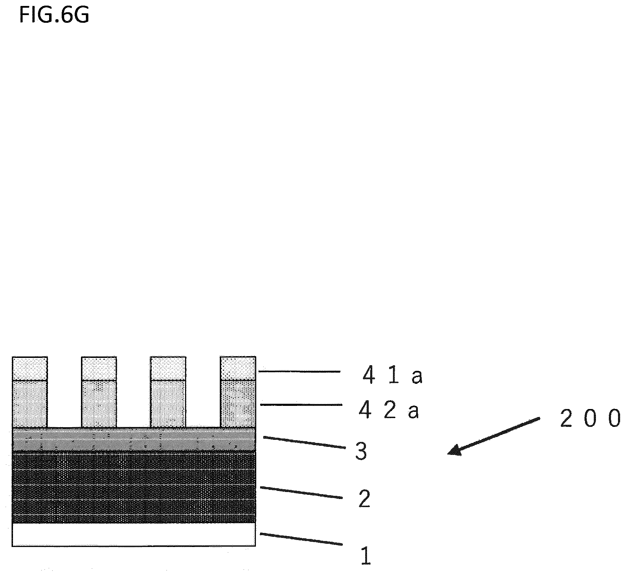

The oxide layer 41 of the light absorbing film is a layer that functions as an etching mask (hard mask) in chlorine-based dry etching containing no oxygen for the absorbing layer 42 of the light absorbing film (see FIG. 6G), and when the absorbing layer 42 of the light absorbing film is subjected to chlorine-based dry etching containing no oxygen under one condition (predetermined same condition), a ratio of an etching rate (nm/sec) of the absorbing layer 42 of the light absorbing film to an etching rate (nm/sec) of the oxide layer 41 of the light absorbing film is preferably 45 or more and particularly 70 or more. By setting the etching rate (nm/sec) to such a ratio, when the absorbing layer pattern of the light absorbing film is formed using the lower hard mask layer pattern of the second layer and the oxide layer pattern of the light absorbing film as the hard masks using chlorine-based dry etching containing no oxygen (see FIG. 6G), after the lower hard mask layer pattern of the second layer disappears, the etching rate of the oxide layer pattern of the light absorbing film is slow, and thus, it is possible to perform long-term over-etching on the absorbing layer pattern of the light absorbing film, and the stability of the CD can be improved. In addition, this increases the process window and allows more dry etching conditions to be used.

### Hard Mask

The hard mask of the present invention includes a multilayer including a first layer provided on a side furthest from the substrate and a second layer provided on a side other than the side furthest from the substrate. The hard mask is not limited to one including two layers, and may include three or more layers, for example, three layers, four layers, or five layers. For the three layers, four layers, or five layers, a film formed of a material having strong cleaning resistance or a film formed of a material having high adhesion to a resist can be used. The second layer is preferably provided on a side closest to the substrate.

The first layer of the hard mask is formed of a material that has resistance to chlorine-based dry etching and can be removed by fluorine-based dry etching. Due to such dry etching characteristics, the first layer functions as an etching mask in etching of the second layer, the oxide layer of the light absorbing film, and the absorbing layer of the light absorbing film. As a material of the first layer, a material containing silicon (Si) and containing no chromium (Cr) is suitable.

On the other hand, the second layer of the hard mask includes the upper hard mask layer 2A of the second layer and the lower hard mask layer 2B of the second layer. The upper hard mask layer 2A of the second layer is formed of a material that has resistance to chlorine-based dry etching and can be removed by fluorine-based dry etching. The lower hard mask layer 2B of the second layer is formed of a material that has resistance to chlorine-based dry etching containing oxygen and can be removed by chlorine-based dry etching containing no oxygen and fluorine-based dry etching. In addition, the upper hard mask layer 2A of the second layer functions as an etching mask in chlorine-based dry etching containing no oxygen in the absorbing layer of the light absorbing film. The upper hard mask layer 2A of the second layer is preferably formed of a material containing tantalum (Ta) and oxygen (O). The material containing tantalum and oxygen may be a tantalum compound containing a material selected from nitrogen (N), boron (B), and the like. Examples of such a material include a material (TaO) formed of tantalum and oxygen, a material (TaON) formed of tantalum, oxygen, and nitrogen, a material (TaOB) formed of tantalum, oxygen, and boron, and a material (TaONB) formed of tantalum, oxygen, nitrogen, and boron. The upper hard mask layer 2A of the second layer may be a single layer film, a multilayer film (for example, a film including 2 to 4 layers), or a film having a gradient composition.

The upper hard mask layer 2A of the second layer is preferably formed of a material that has resistance to chlorine-based dry etching and can be removed by fluorine-based dry etching.

The lower hard mask layer 2B of the second layer is preferably formed in contact with the upper hard mask layer 2A of the second layer.

The lower hard mask layer 2B of the second layer is preferably formed of a material containing tantalum (Ta).

Specific examples of the material containing tantalum include elemental tantalum (Ta) and a tantalum compound containing tantalum (Ta), and one or more selected from nitrogen (N), boron (B), and the like. Examples of such a material include a material (Ta) formed of tantalum, a material (TaN) formed of tantalum and nitrogen, a material (TaB) formed of tantalum and boron, and a material (TaNB) formed of tantalum, nitrogen, and boron. The lower hard mask layer 2B of the second layer may be a single layer film, a multilayer film (for example, a film including 2 to 4 layers), or a film having a gradient composition.

The lower hard mask layer 2B of the second layer is preferably formed of a material that has resistance to chlorine-based dry etching containing oxygen and can be removed by chlorine-based dry etching containing no oxygen and fluorine-based dry etching.

### First Layer

The first layer is a layer in contact with the resist film. In addition, the first layer is a film that functions as an etching mask (hard mask) for the lower hard mask layer 2B of the second layer in chlorine-based dry etching containing no oxygen.

The first layer is preferably formed of a material that has resistance to chlorine-based dry etching and can be removed by fluorine-based dry etching.

A material of the first layer may contain one or more selected from oxygen (O), nitrogen (N), and carbon (C) in addition to silicon, and in particular, a material containing silicon and one or more selected from oxygen, nitrogen, and carbon is preferable. In a case where the material of the first layer contains an element other than silicon, a silicon content ratio is less than 100 atom%, but is preferably 80 atom% or less and particularly 60 atom% or less. The lower the silicon content ratio, the higher the etching rate (etching speed) in fluorine-based dry etching of the first layer. On the other hand, a lower limit of the silicon content ratio is usually 20 atom% or more, and preferably 30 atom% or more.

The material of the first layer preferably contains nitrogen, and silicon nitride (SiN) composed of silicon and nitrogen is particularly preferable. In a case where the material of the first layer contains nitrogen, the silicon content ratio is preferably 20 atom% or more and particularly 30 atom% or more, and is preferably 80 atom% or less and particularly 60 atom% or less. On the other hand, a nitrogen content ratio is preferably 80 atom% or less and particularly 55 atom% or less. A lower limit of the nitrogen content ratio is not particularly limited, and is preferably 20 atom% or more and particularly 30 atom% or more.

The material of the first layer preferably contains oxygen, and silicon oxide (SiO) composed of silicon and oxygen is particularly preferable. In a case where the material of the first layer contains oxygen, the silicon content ratio is preferably 20 atom% or more and particularly 30 atom% or more, and is preferably 80 atom% or less and particularly 60 atom% or less. On the other hand, the oxygen content ratio is preferably 20 atom% or more and particularly 25 atom% or more, and is preferably 80 atom% or less and particularly 68 atom% or less.

The material of the first layer preferably contains nitrogen as well as oxygen, and silicon nitride oxide (SiON) composed of silicon, oxygen, and nitrogen is particularly preferable. The silicon content ratio is preferably 20 atom% or more and particularly 30 atom% or more, and is preferably less than 80 atom% and particularly 60 atom% or less. On the other hand, the oxygen content ratio is preferably more than 0 atom% and less than 80 atom%, and particularly 68 atom% or less. On the other hand, the nitrogen content ratio is preferably more than 0 atom% and less than 80 atom%, and particularly 55 atom% or less.

The first layer is patterned by fluorine-based dry etching using a resist pattern formed in contact with the first layer as an etching mask, but the thinner the first layer, the shorter the etching time, and thus, a thickness of the first layer is preferably 12 nm or less and particularly 10 nm or less. On the other hand, when the thickness is too thin, the function as an etching mask in the etching of the lower hard mask layer 2B of the second layer is lost, and sensitivity of a defect inspection of the first layer is lowered. Therefore, the thickness of the first layer is preferably 2 nm or more and particularly 4 nm or more.

The material containing silicon but no chromium has resistance to chlorine-based dry etching containing no oxygen for the lower hard mask layer 2B of the second layer, and the first layer pattern functions as an etching mask in chlorine-based dry etching containing no oxygen for the lower hard mask layer 2B of the second layer. Furthermore, since the first layer can be etched by fluorine-based dry etching that does not require long-term over-etching, the thickness of the resist film used for etching the first layer can be reduced. In particular, a material containing oxygen together with silicon and containing no chromium, preferably a material containing each element in the content described above, and more preferably a material having a composition having a relatively high oxygen content has high adhesion to a resist film, and is hardly dissolved in a mixed solution of sulfuric acid and aqueous hydrogen peroxide, ammonia added water, or the like as compared with a material containing chromium, and it is possible to stably maintain optical characteristics required for defect inspection and the like. In addition, a material containing oxygen together with silicon and containing no chromium, preferably a material containing each element in the content described above, and more preferably a material having a composition having a relatively high oxygen content has a chemically stable surface state as compared with a material containing tantalum, and the stability of the CD is improved when a resist pattern is produced.

For this reason, the first layer is formed on the side of the etching mask film that is farthest from the substrate, such that even a line pattern such as a fine assist pattern is hardly collapsed due to the impact by the developer or the impact of by the pure water during the rinsing process in the development process of resist pattern formation, an excellent resist pattern can be formed, and high resolution can be stably obtained.

Note that since the material of the first layer, the material of the upper hard mask layer 2A of the second layer, and the material of the lower hard mask layer 2B of the second layer are materials that can be removed by fluorine-based dry etching, the first layer pattern, the upper hard mask layer pattern of the second layer, and the lower hard mask layer pattern of the second layer can be removed simultaneously with formation of the absorbing layer pattern of the light absorbing film in fluorine-based dry etching when the oxide layer pattern of the light absorbing film and the absorbing layer pattern of the light absorbing film are formed.

In particular, in the fluorine-based dry etching when the oxide layer pattern of the light absorbing film and the absorbing layer pattern of the light absorbing film are formed, in order to remove the entire first layer pattern, the entire upper hard mask layer pattern of the second layer, and a part of the lower hard mask layer pattern of the second layer in the thickness direction simultaneously with the formation of the oxide layer pattern of the light absorbing film and the absorbing layer pattern of the light absorbing film, it is advantageous that the total etching clear time when the first layer and the upper hard mask layer 2A of the second layer are subjected to fluorine-based dry etching under one condition is shorter than the total etching clear time of 1/2 of the thicknesses of the oxide layer of the light absorbing film and the absorbing layer of the light absorbing film (under the same conditions as the fluorine-based dry etching of the first layer and the upper hard mask layer 2A of the second layer).

In addition, when the first layer is not included, in the fluorine-based dry etching when the oxide layer pattern of the light absorbing film and the absorbing layer pattern of the light absorbing film are formed, in order to remove the entire upper hard mask layer pattern of the second layer simultaneously with the formation of the oxide layer pattern of the light absorbing film and the absorbing layer pattern of the light absorbing film, it is advantageous that the total etching clear time when the upper hard mask layer 2A of the second layer is subjected to fluorine-based dry etching under one condition is shorter than the etching clear time of 1/2 of the thicknesses of the oxide layer of the light absorbing film and the absorbing layer of the light absorbing film (under the same conditions as the fluorine-based dry etching of the upper hard mask layer 2A of the second layer).

In addition, when the absorbing layer of the light absorbing film and the first layer are subjected to fluorine-based dry etching under one condition, a ratio of an etching rate (nm/sec) of the first layer to an etching rate (nm/sec) of the absorbing layer of the light absorbing film is preferably 0.4 or more and particularly 0.7 or more, but is preferably 2.0 or less and particularly 1.2 or less. Furthermore, a difference between the thickness of the first layer, and the total thickness of the oxide layer of the light absorbing film and the absorbing layer of the light absorbing film is preferably 30 nm or more, particularly 40 nm or more, and further particularly 44 nm or more.

In addition, when the absorbing layer of the light absorbing film and the lower hard mask layer 2B of the second layer are subjected to fluorine-based dry etching under one condition, a ratio of an etching rate (nm/sec) of the lower hard mask layer 2B of the second layer to an etching rate (nm/sec) of the absorbing layer of the light absorbing film is preferably 0.7 or more and particularly 0.8 or more, but is preferably 1.3 or less and particularly 1.2 or less.

In addition, when the absorbing layer of the light absorbing film and the lower hard mask layer 2B of the second layer are subjected to chlorine-based dry etching containing no oxygen under one condition, the ratio of the etching rate (nm/sec) of the lower hard mask layer 2B of the second layer to the etching rate (nm/sec) of the absorbing layer of the light absorbing film is preferably 0.7 or more and particularly 0.8 or more, but is preferably 1.3 or less and particularly 1.2 or less.

### Second Layer

The second layer includes the upper hard mask layer 2A of the second layer and the lower hard mask layer 2B of the second layer, the upper hard mask layer 2A of the second layer is a layer that functions to stabilize a surface layer of the second layer formed of a material containing chemically active tantalum, and the lower hard mask layer 2B of the second layer is a layer that functions as an etching mask (hard mask) in chlorine-based dry etching containing no oxygen for the light absorbing film.

When a thickness of the second layer (a total of a thickness of the upper hard mask layer 2A of the second layer and a thickness of the lower hard mask layer 2B of the second layer) is too thin, the function as an etching mask in etching of the light absorbing film is lost, and the sensitivity of the defect inspection of the second layer is lowered. Therefore, the thickness of the second layer is preferably 8 nm or more and particularly 10 nm or more, and is preferably 30 nm or less and particularly 20 nm or less, in order to shorten the clear time of etching.

The material containing tantalum can be removed by chlorine-based dry etching containing no oxygen. In chlorine-based dry etching containing no oxygen, side etching hardly occurs on a side wall of a pattern, and a pattern shape is perpendicular to a substrate, as compared with chlorine-based dry etching containing oxygen. When large side etching occurs in the line pattern, the dimension near the center of the pattern with respect to the vertical direction is reduced with respect to the upper side and the lower side with respect to the vertical direction of the pattern by the side etching from both sides, and the pattern is easily broken during dry etching, and as a result, resolution is deteriorated.

In addition, the material containing tantalum can be removed by fluorine-based dry etching, and the upper hard mask layer 2A of the second layer formed of tantalum containing oxygen is removed simultaneously when the oxide layer of the light absorbing film and parts of the absorbing layer of the light absorbing film are etched by fluorine-based dry etching. In addition, a part of the lower hard mask layer 2B of the second layer containing tantalum is removed at the same time when a part of the absorbing layer of the light absorbing film is etched by fluorine-based dry etching.

Thereafter, chlorine-based dry etching containing no oxygen is performed on the absorbing layer of the remaining light absorbing film to form an absorbing layer pattern of the light absorbing film, and at the same time, a part of the lower hard mask layer 2B of the second layer remaining as described above is removed. Since the oxide layer of the light absorbing film includes the oxide layer containing oxygen, the light absorbing film has resistance to chlorine etching containing no oxygen, and functions as an etching prevention film when a part of the lower hard mask layer 2B of the second layer is removed. In addition, since chlorine etching containing no oxygen is performed when the absorbing layer pattern of the light absorbing film is formed, the thickness of the protective film having resistance to chlorine etching containing no oxygen does not decrease. Chlorine-based dry etching containing oxygen has high reactivity to ruthenium and has a higher etching rate than chlorine-based dry etching containing no oxygen. Therefore, when the protective film is etched for a long time by chlorine-based dry etching containing oxygen, the protective film is completely removed, and the function of the protective film is lost.

For this reason, the upper hard mask layer 2A of the second layer and the lower hard mask layer 2B of the second layer are provided together with the first layer in the etching mask film, such that high resolution can be obtained and the film thickness of the protective film can be maintained.

In addition, in order to obtain the above effect, the upper hard mask layer 2A of the second layer is preferably tantalum oxynitride containing tantalum, oxygen, and nitrogen, and the lower hard mask layer 2B of the second layer is preferably tantalum nitride containing tantalum and nitrogen.

In order that the lower hard mask layer 2B of the second layer can be removed by chlorine-based dry etching containing no oxygen, an oxygen content ratio is preferably 5% or less and is particularly preferably 3% or less.

In order for the upper hard mask layer 2A of the second layer to have resistance to chlorine-based dry etching containing no oxygen, the oxygen content ratio is preferably 15% or more and is particularly preferably 18% or more.

In addition, the upper hard mask layer 2A of the second layer is a layer that functions as an etching mask (hard mask) in chlorine-based dry etching containing no oxygen for the lower hard mask layer 2B of the second layer, and when the lower hard mask layer 2B of the second layer is subjected to chlorine-based dry etching containing no oxygen under the same conditions, it is preferable that the ratio of the etching rate (nm/sec) of the lower hard mask layer 2B of the second layer to the etching rate (nm/sec) of the upper hard mask layer 2A of the second layer is 45 or more, and particularly 70 or more.

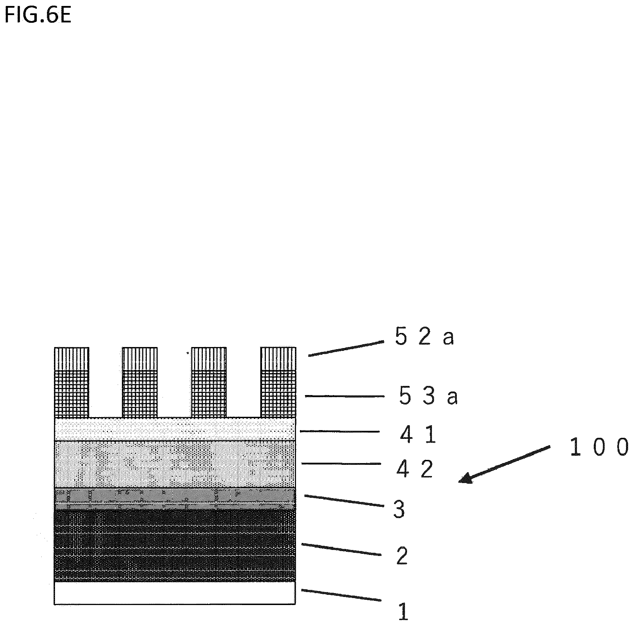

By setting the etching rate (nm/sec) to such a ratio, as illustrated in FIG. 6E, when the lower hard mask layer pattern of the second layer is formed using the upper hard mask layer pattern of the second layer as a hard mask using chlorine-based dry etching containing no oxygen, the etching rate of the upper hard mask layer pattern of the second layer is slow, and thus, it is possible to perform long over-etching on the lower hard mask layer pattern of the second layer, which improves CD stability. In addition, this increases the process window and allows more dry etching conditions to be used.

Note that, since the lower hard mask layer 2B of the second layer is a material that can be removed by dry etching containing no oxygen, the absorbing layer of the light absorbing film can be removed simultaneously when being removed by dry etching containing no oxygen.

### Resist Film

The resist film may be an electron beam resist drawn by an electron beam or a photoresist drawn by light, and a chemically amplified resist is preferable. The chemically amplified resist may be a positive type or a negative type, and examples thereof include a chemically amplified resist containing a base resin such as a hydroxystyrene-based resin or a (meth)acrylic acid-based resin, and an acid generator, and a crosslinking agent, a quencher, a surfactant, or the like that is added as necessary.

The thickness of the resist film formed on the first layer of the present invention can be reduced as described above. The thickness of the resist film is preferably 80 nm or less from the viewpoint of making the resist pattern for forming a fine assist pattern less prone to collapse by the impact by the developer or the impact by the pure water during the rinsing process in the development process of resist pattern formation, and is preferably 70 nm or less and particularly 60 nm or less from the viewpoint of preferably forming a line pattern such as an assist pattern having a width of about 25 nm and particularly about 20 nm. A lower limit of the thickness of the resist film is a thickness that functions as an etching mask in etching of the first layer, may be a thickness at which the resist pattern remains on the entire pattern of the first layer after etching, is not particularly limited, and is preferably 15 nm or more, and particularly 20 nm or more.

The multilayer reflective film, the protective film, the light absorbing film, and the first layer and the upper hard mask layer 2A of the second layer and the lower hard mask layer 2B of the second layer of the present invention are not particularly limited, and are preferably formed by a sputtering method because these films have excellent controllability and easily form films having predetermined characteristics. DC sputtering, RF sputtering, and the like can be applied as the sputtering method, and there is no particular limitation.

When a laminated film of a molybdenum layer and a silicon layer is formed as the multilayer reflective film, a molybdenum target and a silicon target can be used as the sputtering target. When a film formed of a material containing ruthenium is formed as the protective film, a ruthenium target can be used as the sputtering target. When a film formed of a material containing tantalum is formed as the light absorbing film, a tantalum target can be used as the sputtering target. When a first layer formed of a material containing silicon but no chromium is formed, a silicon target can be used as the sputter target.

Power supplied to the sputtering target may be appropriately set depending on the size of the sputtering target, cooling efficiency, ease of film formation control, and the like, and usually, power per area of a sputtering surface of the sputtering target may be 50 to 3,000 W/cm². In addition, as the sputtering gas, a rare gas such as helium gas (He gas), neon gas (Ne gas), or argon gas (Ar gas) is used, and when each of the film and the layer included in the film is formed using only the target element, only rare gas may be used as the sputtering gas. In the case of formation with only the target element, only rare gas may be used as the sputtering gas.

When each of the film and the layer included in the film is formed of a material containing oxygen, nitrogen, or carbon, the sputtering is preferably reactive sputtering. As the sputtering gas for reactive sputtering, rare gases such as helium gas (He gas), neon gas (Ne gas), argon gas (Ar gas), and reactive gases are used. For example, oxygen gas (O₂ gas) may be used as the reactive gas in the case where each of the film and the layer is formed of a material containing oxygen, and nitrogen gas (N₂ gas) may be used as the reactive gas in the case where each of the film and the layer is formed of a material containing nitrogen. In a case where each of the film and the layer is formed of a material containing both nitrogen and oxygen, the reactive gas may be appropriately selected and used from oxygen gas (O₂ gas), nitrogen gas (N₂ gas), and nitrogen oxide gas such as nitrogen monoxide gas (NO gas), nitrogen dioxide gas (NO₂ gas), or nitrous oxide gas (N₂O gas). In a case where each of the film and the layer is formed of a material containing carbon, gas containing carbon such as methane gas (CH₄), carbon monoxide gas (CO gas), or carbon dioxide gas (CO₂ gas) may be used as the reactive gas, and in a case where the film is formed of a material containing oxygen, nitrogen, and carbon, for example, oxygen gas (O₂ gas), nitrogen gas (N₂ gas), and carbon dioxide gas (CO₂) may be simultaneously used as the reactive gas.

The pressure at the time of forming each of the film and the layer included in the film may be appropriately set in consideration of film stress, chemical resistance, cleaning resistance, and the like, and the chemical resistance is usually improved by setting the pressure to 0.01 Pa or more, particularly 0.03 Pa or more and 1 Pa or less, and more particularly 0.3 Pa or less. In addition, each gas flow rate may be appropriately set so as to have a desired composition, and may be usually 0.1 to 100 sccm.

In the manufacturing process of the reflective photomask blank, before the resist film is formed, the substrate or the substrate and the film formed on the substrate may be subjected to a heat treatment. As a method of the heat treatment, infrared heating, resistance heating, and the like can be applied, and conditions of the treatment are not particularly limited. The heat treatment can be performed, for example, in a gas atmosphere containing oxygen. A concentration of the gas containing oxygen is not particularly limited, and can be, for example, 1 to 100 vol% in the case of oxygen gas (O₂ gas). A temperature of the heat treatment is preferably 200°C or higher and particularly 400°C or higher.

In addition, in the manufacturing process of the reflective photomask blank, before the resist film is formed, the film formed on the substrate, particularly the first layer, may be subjected to an ozone treatment, a plasma treatment, or the like, and the conditions of the treatment are not particularly limited. Any treatment can be performed for the purpose of increasing the oxygen concentration of the surface part of the film, and in this case, the treatment conditions may be appropriately adjusted so as to have a predetermined oxygen concentration. Note that, in a case where the film is formed by sputtering, the oxygen concentration of the surface part of the film can be increased by adjusting a ratio of a rare gas in the sputtering gas to a gas containing oxygen (oxidizing gas) such as oxygen gas (O₂ gas), carbon monoxide gas (CO gas), or carbon dioxide gas (CO₂ gas).

In addition, the first layer may be a single layer film, a multilayer film (for example, a film including 2 to 4 layers), or a film having a gradient composition. In the first layer, in a case where a content of silicon is low, a content of nitrogen or oxygen, or a content of nitrogen and oxygen is high, the etching rate by the fluorine-based gas is increased, and the film thickness of the resist film can be reduced, but the surface roughness of the film surface layer is reduced, the adhesion between the first layer and the resist film is poor, and the resolution of the resist pattern is deteriorated. On the other hand, in a case where the content of silicon is high, the content of nitrogen or oxygen, or the content of nitrogen and oxygen is low, the etching rate by the fluorine-based gas is decreased, and the film thickness of the resist film cannot be reduced, but the surface roughness of the film surface layer is increased, the adhesion between the first layer and the resist film is excellent, and the resolution of the resist pattern is improved. Therefore, as for the composition of the first layer on the side that is spaced from the substrate, a film in which a content of silicon is high, a content of nitrogen or oxygen, or a content of nitrogen and oxygen is low, a content of silicon is low toward the substrate direction, and a content of nitrogen or oxygen, or a content of nitrogen and oxygen is high is preferable because adhesion with the resist film is excellent, and the etching rate can be fast.

Furthermore, in the manufacturing process of the reflective photomask blank, before the resist film is formed, a cleaning process may be performed in order to remove defects present on the surface of the substrate or the film formed on the substrate. The cleaning can be performed using one or both of ultrapure water and functional water that is ultrapure water containing ozone gas, hydrogen gas, and the like. In addition, after cleaning with ultrapure water containing a surfactant, cleaning may be further performed using one or both of ultrapure water and functional water. The cleaning can be performed while performing irradiation with ultrasonic waves as necessary, and UV light irradiation can also be combined.

The method for forming the resist film (coating of the resist) is not particularly limited, and a known method can be applied.

Next, a method for manufacturing a reflective photomask from a reflective photomask blank according to a first aspect of the present invention will be described with reference to the drawings. In a case where a reflective photomask is manufactured from a reflective photomask blank of the present invention, it is possible to apply a method in which a resist pattern is formed from a resist film, dry etching using fluorine-based gas (fluorine-based dry etching) or dry etching using chlorine-based gas (chlorine-based dry etching) is applied to a film or a layer under the film using the resist pattern as an etching mask according to a material forming the film or the layer, the pattern is formed, and the pattern is removed at an appropriate time. In addition, in the manufacture of the reflective photomask, the resist film and the resist pattern can be removed by sulfuric acid hydrogen peroxide.

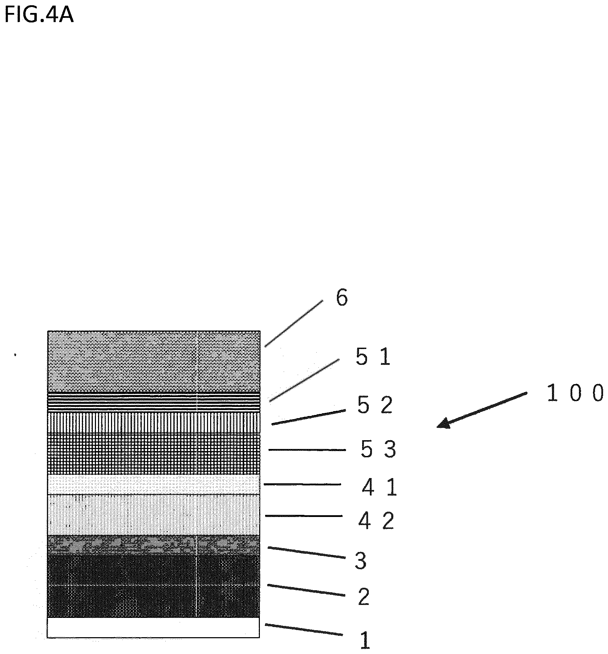

FIGS. 4A to 4G are cross-sectional views for explaining a process of manufacturing a reflective photomask from a reflective photomask blank of the present invention. First, as illustrated in FIG. 4A, a resist film 6 is formed in contact with a side of a reflective photomask blank 100 of the first aspect that is spaced from a substrate 1 (that is, in contact with a first layer 51) (step (A)).

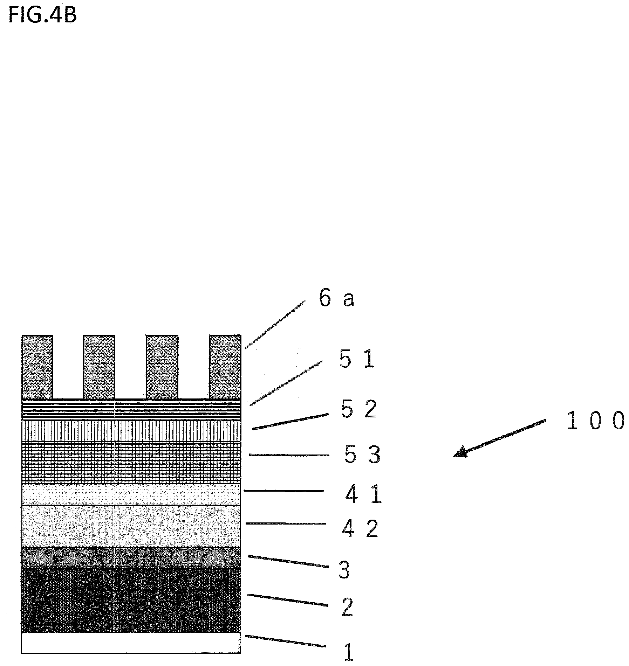

Next, as illustrated in FIG. 4B, the resist film 6 is patterned to form a resist film pattern 6a (step (B)).

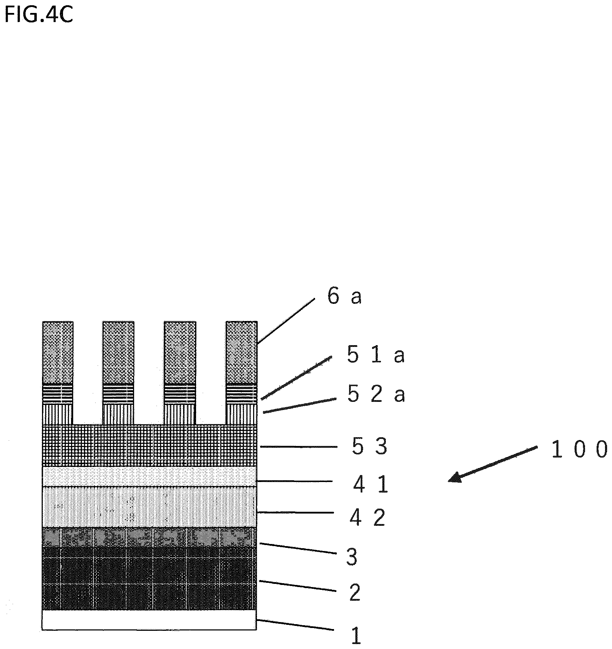

Next, as illustrated in FIG. 4C, using the resist pattern 6a as an etching mask, a first layer 51 and an upper hard mask layer 2A of a second layer are simultaneously patterned by dry etching using fluorine-based gas to form a first layer pattern 51a and an upper hard mask layer pattern 52a of the second layer

### (step (C)).

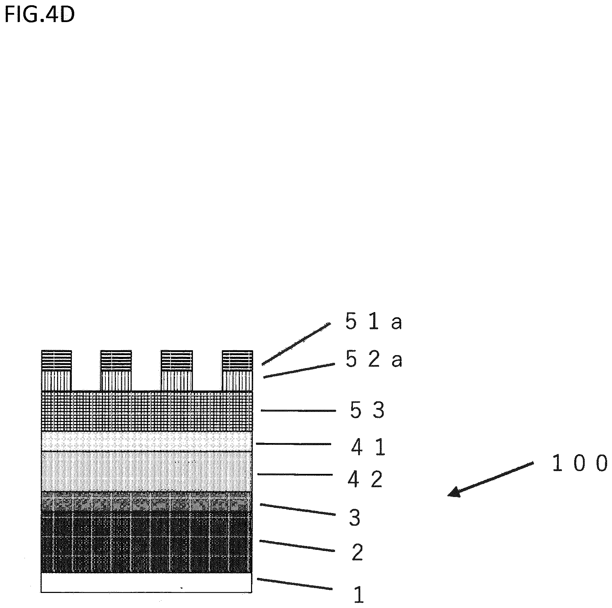

Next, as illustrated in FIG. 4D, the resist pattern 6a is removed (step (D)).

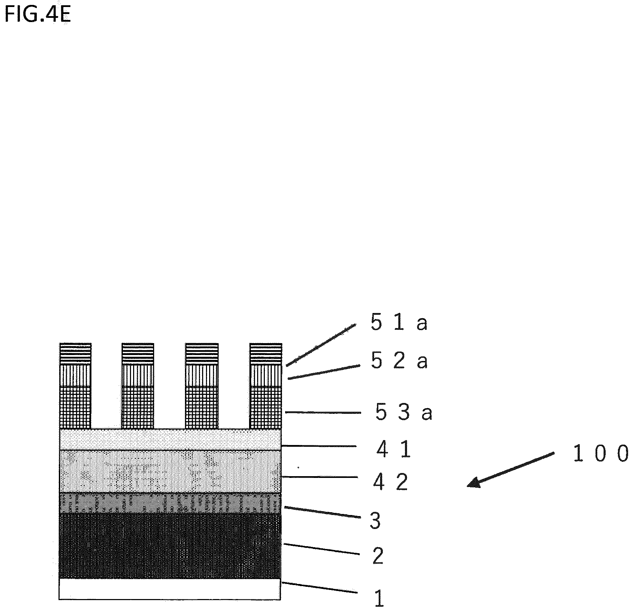

Next, as illustrated in FIG. 4E, using the first layer pattern 51a and the upper hard mask layer pattern 52a of the second layer as etching masks, a lower hard mask layer 2B of the second layer is patterned by dry etching using chlorine-based gas containing no oxygen to form a lower hard mask layer pattern 53a of the second layer (step (E)).

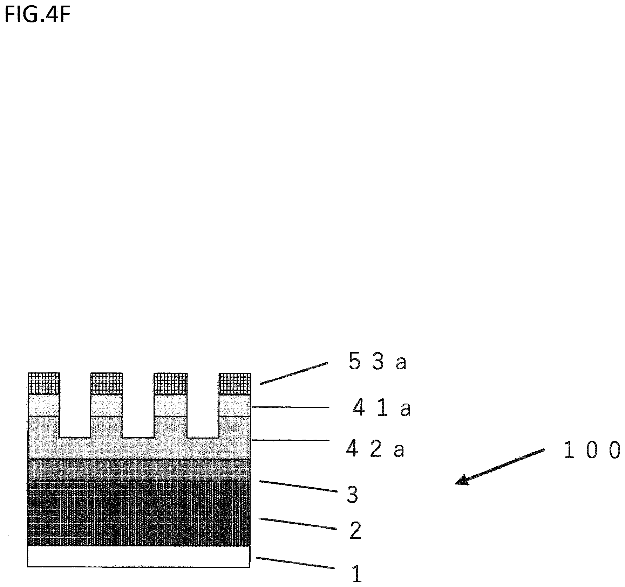

Next, as illustrated in FIG. 4F, using the first layer pattern 51a, the upper hard mask layer pattern 52a of the second layer, and the lower hard mask layer pattern 53a of the second layer as hard masks, an oxide layer 41 of a light absorbing film and parts of an absorbing layer 42 of the light absorbing film are patterned by fluorine-based dry etching to form an oxide layer pattern 41a and an absorbing layer pattern 42a of the light absorbing film. Here, the absorbing layer 42 of the light absorbing film is not entirely etched, and a part thereof remains (step (F)).

In addition, when the oxide layer 41 of the light absorbing film and parts of the absorbing layer 42 of the light absorbing film are patterned by fluorine-based dry etching, the first layer pattern 51a, the upper hard mask layer pattern 52a of the second layer, and parts of the lower hard mask layer pattern 53a of the second layer are simultaneously removed. After the dry etching, a part of the lower hard mask layer pattern 53a remains on the oxide layer pattern 41a of the light absorbing film.

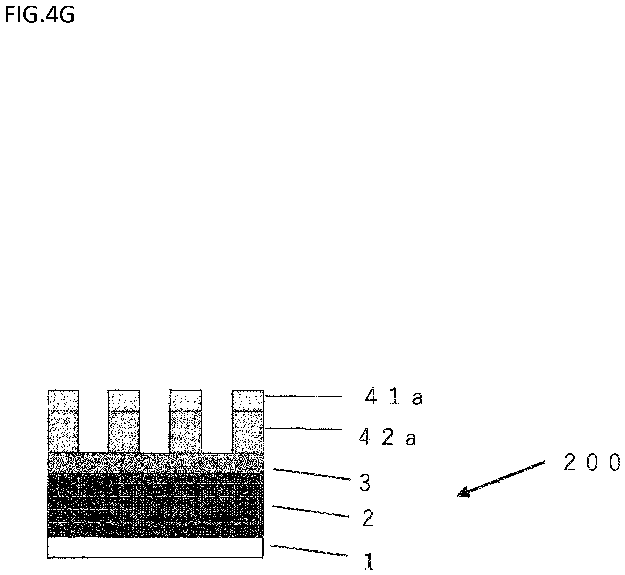

Next, as illustrated in FIG. 4G, using the lower hard mask layer pattern 53a of the second layer and the oxide layer pattern 41a of the light absorbing film as etching masks, the absorbing layer pattern 42a of the light absorbing film remaining in FIG. 4F is removed by dry etching using chlorine-based gas containing no oxygen (step (G)). In this case, the remaining lower hard mask layer pattern 53a of the second layer is simultaneously removed and held by chlorine-based dry etching containing no oxygen. (The oxide film pattern 41a of the light absorbing film has resistance to chlorine-based dry etching containing no oxygen, and thus functions as an etching prevention film.)

After chlorine-based dry etching containing no oxygen, only the absorbing layer pattern 42a of the light absorbing film and the oxide layer pattern 41a of the light absorbing film remain on a protective film 3.

In a case where a reflective photomask is manufactured from a reflective photomask blank according to a second aspect of the present invention, a resist film is formed in advance, and thus, the step (A) can be omitted, and the steps (B) to (G) may be performed.

With such a method, a thin resist film is formed on a reflective photomask blank so as to have a thickness of, for example, 60 nm or less, or a light absorbing film is patterned from a reflective photomask blank in which a thin resist film having a thickness of, for example, 60 nm or less is formed, such that it is possible to obtain a reflective photomask in which a pattern of a light absorbing film including a line pattern such as an assist pattern that is excellent even when a line width is 25 nm or less (25 nm or less than 25 nm), and particularly 20 nm or less (20 nm or less than 20 nm) is formed. Furthermore, as in the step of FIG. 4G, the protective film 3 is exposed to dry etching using chlorine-based gas containing no oxygen, and there is no damage and the thickness of the film does not decrease. Note that, in the present invention, a lower limit of a width of the line pattern such as the assist pattern formed in the light absorbing film pattern of the reflective photomask is usually 10 nm or more.

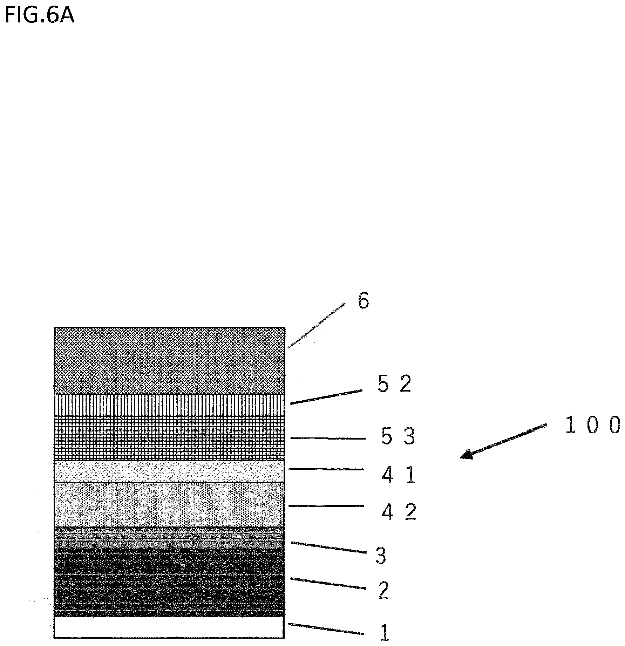

FIG. 5 is a cross-sectional view for explaining a process of manufacturing a reflective photomask from the reflective photomask blank according to a third aspect of the present invention. First, as illustrated in FIG. 6A, a resist film 6 is formed in contact with a side of a reflective photomask blank 100 of the third aspect that is spaced from a substrate 1 (that is, in contact with an upper hard mask layer 2A of a second layer) (step (A)).

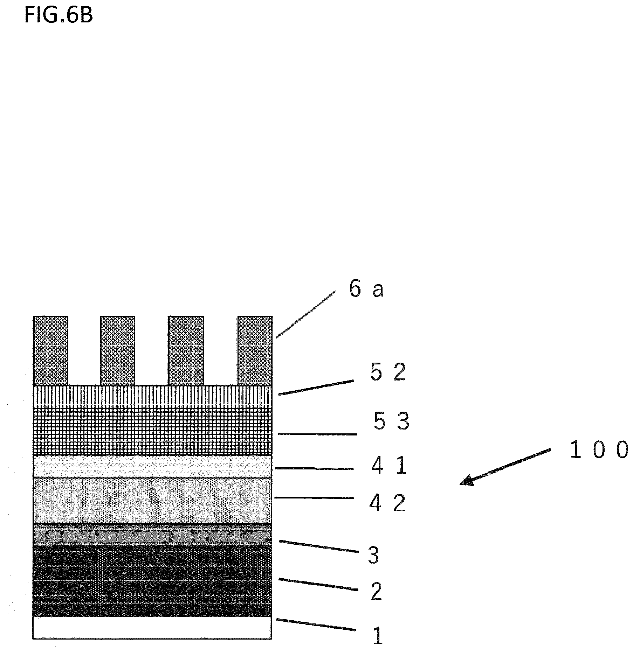

Next, as illustrated in FIG. 6B, the resist film 6 is patterned to form a resist film pattern 6a (step (B)).

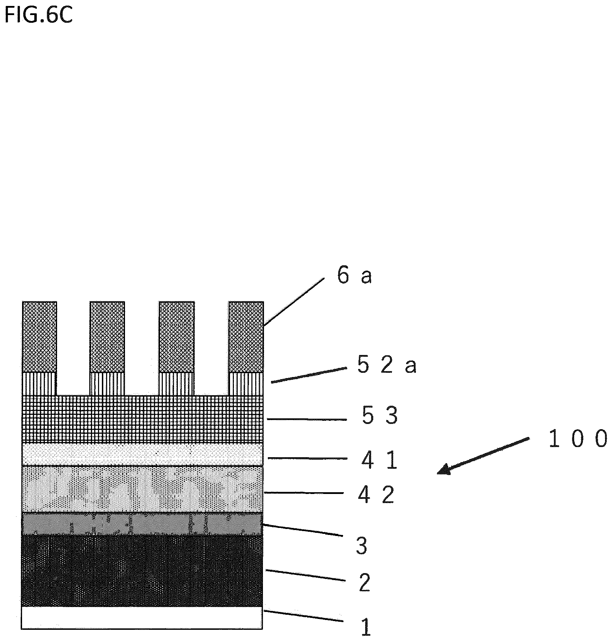

Next, as illustrated in FIG. 6C, using the resist pattern 6a as an etching mask, an upper hard mask layer 2A of a second layer is patterned by dry etching using fluorine-based gas to form an upper hard mask layer pattern 52a of the second layer

### (step (C)).

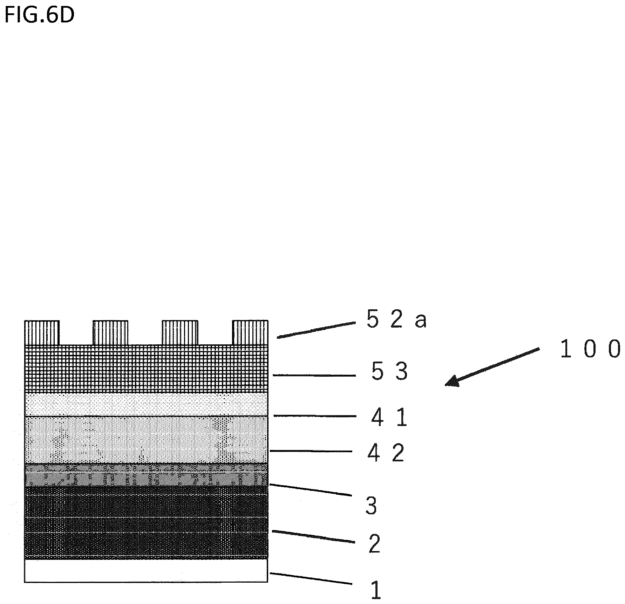

Next, as illustrated in FIG. 6D, the resist pattern 6a is removed (step (D)).

Next, as illustrated in FIG. 6E, using the upper hard mask layer pattern 52a of the second layer as an etching mask, a lower hard mask layer 2B of the second layer is patterned by dry etching using chlorine-based gas containing no oxygen to form the lower hard mask layer pattern 53a of the second layer (step (E)).

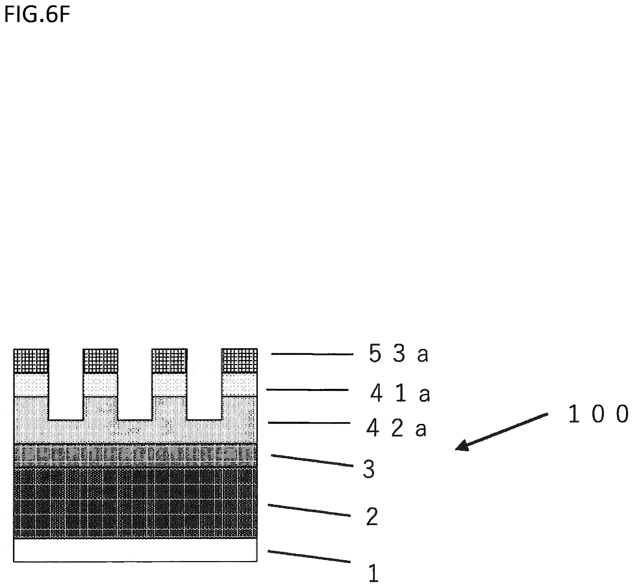

Next, as illustrated in FIG. 6F, using the upper hard mask layer pattern 52a of the second layer and the lower hard mask layer pattern 53a of the second layer as hard masks, an oxide layer 41 of a light absorbing film and an parts of absorbing layer 42 of the light absorbing film are patterned by fluorine-based dry etching to form an oxide layer pattern 41a and an absorbing layer pattern 42a of the light absorbing film. Here, the absorbing layer 42 of the light absorbing film is not entirely etched, and a part thereof remains (step (F)).

In addition, when the oxide layer 41 of the light absorbing film and parts of the absorbing layer 42 of the light absorbing film are patterned by fluorine-based dry etching, the upper hard mask layer pattern 52a of the second layer and parts of the lower hard mask layer pattern 53a of the second layer are simultaneously removed. After the dry etching, a part of the lower hard mask layer pattern 53a remains on the oxide layer pattern 41a of the light absorbing film.

Next, as illustrated in FIG. 6G, using the lower hard mask layer pattern 53a of the second layer and the oxide layer pattern 41a of the light absorbing film as etching masks, the absorbing layer pattern 42a of the light absorbing film remaining in FIG. 6F is removed by dry etching using chlorine-based gas containing no oxygen (step (G)). In this case, the remaining lower hard mask layer pattern 53a of the second layer is simultaneously removed and held by chlorine-based dry etching containing no oxygen. (The oxide film pattern 41a of the light absorbing film has resistance to chlorine-based dry etching containing no oxygen, and thus functions as an etching prevention film.)

After chlorine-based dry etching containing no oxygen, only the absorbing layer pattern 42a of the light absorbing film and the oxide layer pattern 41a of the light absorbing film remain on a protective film 3.

In a case where a reflective photomask is manufactured from a reflective photomask blank according to a fourth aspect of the present invention in which a resist film is already formed, the step (A) can be omitted, and the steps (B) to (G) may be performed.

With such a method, a thin resist film is formed on a reflective photomask blank that does not include a first layer so as to have a thickness of, for example, 60 nm or less, or a light absorbing film is patterned from a reflective photomask blank in which a thin resist film having a thickness of, for example, 60 nm or less is formed, such that it is possible to obtain a reflective photomask, in which a pattern of a light absorbing film including a line pattern such as an assist pattern that is excellent even when a line width is 25 nm or less (25 nm or less than 25 nm), and particularly 20 nm or less (20 nm or less than 20 nm), is formed. Furthermore, as in the step of FIG. 6G, the protective film 3 is exposed to dry etching using chlorine-based gas containing no oxygen, and there is no damage and the thickness of the film does not decrease.

Note that, in the present invention, a lower limit of a width of the line pattern such as the assist pattern formed in the light absorbing film pattern of the reflective photomask is usually 10 nm or more.

### Examples

Hereinafter, the present invention will be specifically described with reference to Examples and Comparative Examples, but the present invention is not limited to the following Examples.

### Example 1

A multilayer reflective film, a protective film, a light absorbing film, and a hard mask including a first layer and a second layer were sequentially laminated on a quartz substrate having a size of 152 mm square and a thickness of about 6 mm to manufacture a reflective photomask blank (reflective photomask blank of a first aspect) as illustrated in FIG. 1.

First, a molybdenum target and a silicon target were used as targets, argon gas was used as sputtering gas, power applied to the target was adjusted, a flow rate of the sputtering gas was adjusted, and sputtering by the molybdenum target and sputtering by the silicon target were alternately performed to form a multilayer reflective film 2 that is a laminated film (thickness: 280 nm) in which a molybdenum (Mo) layer and a silicon (Si) layer having a reflectance for light having a wavelength of 13.5 nm of 65% were alternately laminated on the quartz substrate that is a substrate 1. A total of 40 layers were formed by combining molybdenum (Mo) layers and silicon layers.

Next, sputtering was performed by using ruthenium as a target, using argon gas as sputtering gas, adjusting power applied to the target, and adjusting a flow rate of the sputtering gas to form a ruthenium (Ru) film (thickness: 5 nm) on the multilayer reflective film as a protective film 3 formed of a material containing ruthenium.

Next, sputtering was performed by using a tantalum target as a target, using argon gas and nitrogen gas as sputtering gas, adjusting power applied to the target, and adjusting a flow rate of the sputtering gas to form a tantalum nitride (TaN) film (thickness: 65 nm) on the protective film as an absorbing layer 42 of a light absorbing film formed of a material containing tantalum.

Next, sputtering was performed by using a tantalum target as a target, using argon gas and oxygen gas as sputtering gas, adjusting power applied to the target, and adjusting a flow rate of the sputtering gas to form a tantalum oxide (TaO) film (thickness: 3 nm) on the absorbing layer 42 of the light absorbing film as an oxide layer 41 of the light absorbing film formed of a material containing tantalum.

Next, sputtering was performed by using a tantalum target as a target, using argon gas and nitrogen gas as sputtering gas, adjusting power applied to the target, and adjusting a flow rate of the sputtering gas to form a tantalum nitride (TaN) film (thickness: 10 nm) on the oxide layer of the light absorbing film as a lower hard mask layer 53 of the second layer formed of a material containing tantalum.

Next, sputtering was performed by using a tantalum target as a target, using argon gas and oxygen gas as sputtering gas, adjusting power applied to the target, and adjusting a flow rate of the sputtering gas to form a tantalum oxynitride (TaON) film (thickness: 3 nm) on the lower hard mask layer 53 of the second layer as an upper hard mask layer 52 of the second layer formed of a material containing tantalum.

Furthermore, sputtering was performed by using a silicon target as a target, using argon gas and nitrogen gas as sputtering gas, adjusting power applied to the target, and adjusting a flow rate of the sputtering gas to form a silicon nitride (SiN) layer (thickness: 10 nm) on the second layer as a first layer 51 formed of a material containing silicon but no chromium and obtain a reflective photomask blank. The composition and thickness of the first layer 51, the thickness of the upper hard mask layer 52 of the second layer, the thickness of the lower hard mask layer 53 of the second layer, the material of the lower hard mask layer 53 of the second layer, the thickness of the oxide layer 41 of the light absorbing film, and the thickness of the absorbing layer 42 of the light absorbing film are shown in Table 1. Note that the composition was measured using an X-ray photoelectron spectrometer, and the thickness was measured using an X-ray diffractometer (the same applies hereinafter).

### Example 2

A reflective photomask blank was obtained in the same manner as in Example 1, except that the formation of the first layer 51 was changed as follows and the thickness of the lower hard mask layer 53 of the second layer was changed. Sputtering was performed on the first layer 51 by using a silicon target as a target, using argon gas and oxygen gas as sputtering gas, adjusting power applied to the target, and adjusting a flow rate of the sputtering gas to form a silicon oxide (SiO) layer on the second layer as the first layer 51 formed of a material containing silicon but no chromium. The composition and thickness of the first layer 51, the thickness of the upper hard mask layer 52 of the second layer, the thickness of the lower hard mask layer 53 of the second layer, the material of the lower hard mask layer 53 of the second layer, the thickness of the oxide layer 41 of the light absorbing film, and the thickness of the absorbing layer 42 of the light absorbing film are shown in Table 1.

### Example 3

A reflective photomask blank was obtained in the same manner as in Example 1, except that the formation of the first layer 51 was changed as follows. Sputtering was performed on the first layer 51 by using a silicon target as a target, using argon gas, nitrogen gas, and oxygen gas as sputtering gas, adjusting power applied to the target, and adjusting a flow rate of the sputtering gas to form a silicon nitride oxide (SiON) layer on the second layer as the first layer 51 formed of a material containing silicon but no chromium. The composition and thickness of the first layer 51, the thickness of the upper hard mask layer 52 of the second layer, the thickness of the lower hard mask layer 53 of the second layer, the material of the lower hard mask layer 53 of the second layer, the thickness of the oxide layer 41 of the light absorbing film, and the thickness of the absorbing layer 42 of the light absorbing film are shown in Table 1.

### Example 4

A reflective photomask blank was obtained in the same manner as in Example 3, except that the ratio of silicon, oxygen, and nitrogen in the first layer 51 was changed. The composition and thickness of the first layer 51, the thickness of the upper hard mask layer 52 of the second layer, the thickness of the lower hard mask layer 53 of the second layer, the material of the lower hard mask layer 53 of the second layer, the thickness of the oxide layer 41 of the light absorbing film, and the thickness of the absorbing layer 42 of the light absorbing film are shown in Table 1.

### Example 5

A reflective photomask blank was obtained in the same manner as in Example 2, except that the ratio of silicon, oxygen, and nitrogen in the first layer 51 was changed and the thickness of the lower hard mask layer 53 of the second layer was changed. The composition and thickness of the first layer 51, the thickness of the upper hard mask layer 52 of the second layer, the thickness of the lower hard mask layer 53 of the second layer, the material of the lower hard mask layer 53 of the second layer, the thickness of the oxide layer 41 of the light absorbing film, and the thickness of the absorbing layer 42 of the light absorbing film are shown in Table 1.

### Example 6

A reflective photomask blank was obtained in the same manner as in Example 5, except that the thickness of the upper hard mask layer 52 of the second layer and the thickness of the lower hard mask layer 53 of the second layer were changed. The composition and thickness of the first layer 51, the thickness of the upper hard mask layer 52 of the second layer, the thickness of the lower hard mask layer 53 of the second layer, the material of the lower hard mask layer 53 of the second layer, the thickness of the oxide layer 41 of the light absorbing film, and the thickness of the absorbing layer 42 of the light absorbing film are shown in Table 1.

### Example 7

A reflective photomask blank was obtained in the same manner as in Example 5, except that the thickness of the upper hard mask layer 52 of the second layer and the thickness of the lower hard mask layer 53 of the second layer were changed. The composition and thickness of the first layer 51, the thickness of the upper hard mask layer 52 of the second layer, the thickness of the lower hard mask layer 53 of the second layer, the material of the lower hard mask layer 53 of the second layer, the thickness of the oxide layer 41 of the light absorbing film, and the thickness of the absorbing layer 42 of the light absorbing film are shown in Table 1.

### Example 8

A reflective photomask blank was obtained in the same manner as in Example 5, except that the thickness of the first layer 51, the thickness of the upper hard mask layer 52 of the second layer, and the thickness of the lower hard mask layer 53 of the second layer were changed. The composition and thickness of the first layer 51, the thickness of the upper hard mask layer 52 of the second layer, the thickness of the lower hard mask layer 53 of the second layer, the material of the lower hard mask layer 53 of the second layer, the thickness of the oxide layer 41 of the light absorbing film, and the thickness of the absorbing layer 42 of the light absorbing film are shown in Table 1.

### Example 9

A reflective photomask blank was obtained in the same manner as in Example 5, except that the thickness of the first layer 51 and the thickness of the upper hard mask layer 52 of the second layer were changed. The composition and thickness of the first layer 51, the thickness of the upper hard mask layer 52 of the second layer, the thickness of the lower hard mask layer 53 of the second layer, the material of the lower hard mask layer 53 of the second layer, the thickness of the oxide layer 41 of the light absorbing film, and the thickness of the absorbing layer 42 of the light absorbing film are shown in Table 1.

### Example 10

A reflective photomask blank was obtained in the same manner as in Example 5, except that the material of the lower hard mask layer 53 of the second layer and the thickness of the lower hard mask layer 53 of the second layer were changed. The composition and thickness of the first layer 51, the thickness of the upper hard mask layer 52 of the second layer, the thickness of the lower hard mask layer 53 of the second layer, the material of the lower hard mask layer 53 of the second layer, the thickness of the oxide layer 41 of the light absorbing film, and the thickness of the absorbing layer 42 of the light absorbing film are shown in Table 1.

### Example 11

A reflective photomask blank was obtained in the same manner as in Example 10, except that the hard mask of the first layer 51 was not provided. The thickness of the upper hard mask layer 52 of the second layer, the thickness of the lower hard mask layer 53 of the second layer, the material of the lower hard mask layer 53 of the second layer, the thickness of the oxide layer 41 of the light absorbing film, and the thickness of the absorbing layer 42 of the light absorbing film are shown in Table 1.

### Comparative Example 1

A reflective photomask blank was obtained in the same manner as in Example 5, except that a hard mask layer (corresponding to the upper hard mask layer 52 of the second layer and the lower hard mask layer 53 of the second layer) including only a layer formed of a material containing chromium and containing no silicon was formed on the oxide layer 41 of the light absorbing film. The composition and thickness of the first layer 51, the thickness of the hard mask layer of the second layer, the material of the hard mask layer of the second layer, the thickness of the oxide layer 41 of the light absorbing film, and the thickness of the absorbing layer 42 of the light absorbing film are shown in Table 1.

### Comparative Example 2

A reflective photomask blank was obtained in the same manner as in Comparative Example 1 except for the thickness of the hard mask layer. The composition and thickness of the first layer 51, the thickness of the hard mask layer of the second layer, the material of the hard mask layer of the second layer, the thickness of the oxide layer 41 of the light absorbing film, and the thickness of the absorbing layer 42 of the light absorbing film are shown in Table 1.

### Comparative Example 3

A reflective photomask blank was obtained in the same manner as in Comparative Example 1, except that a hard mask layer (corresponding to the hard mask layer including only the second layer) including only a layer formed of a material containing chromium and containing no silicon was formed on the oxide layer 41 of the light absorbing film. The material of the hard mask layer, the thickness of the oxide layer 41 of the light absorbing film, and the thickness of the absorbing layer 42 of the light absorbing film are shown in Table 1.

### Comparative Example 4

A reflective photomask blank was obtained in the same manner as in Comparative Example 2, except that a hard mask layer (corresponding to the hard mask layer including only the second layer) including only a layer formed of a material containing chromium and containing no silicon was formed on the oxide layer 41 of the light absorbing film. The material of the hard mask layer, the thickness of the oxide layer 41 of the light absorbing film, and the thickness of the absorbing layer 42 of the light absorbing film are shown in Table 1.

**[Table 1]**

| | First layer | | | | Upper hard mask layer 2A of second layer | | | | | Lower hard mask layer 2B of second layer | | | | | | Oxide layer of light absorbing film | Absorbing layer of light absorbing film |
|---|---|---|---|---|---|---|---|---|---|---|---|---|---|---|---|---|---|
| | Composition [atom%] | | | Film thickness [nm] | Film thickness [nm] | Material | Composition [atom%] | | | Film thickness [nm] | Material | Composition [atom%] | | | | | |
| | Silicon | Oxygen | Nitrogen | | | | Tantalum | Oxygen | Nitrogen | | | Tantalum | Oxygen | Nitrogen | Chromium | Film thickness [nm] | Film thickness [nm] |
| Example 1 | 47 | 0 | 53 | 10 | 3 | Tantalum oxynitride | 40 | 20 | 40 | 10 | Tantalum nitride | 60 | 0 | 40 | 0 | 3 | 65 |
| Example 2 | 72 | 28 | 0 | 10 | 3 | Tantalum oxynitride | 40 | 20 | 40 | 14 | Tantalum nitride | 60 | 0 | 40 | 0 | 3 | 65 |
| Example 3 | 32 | 66 | 2 | 10 | 3 | Tantalum oxynitride | 40 | 20 | 40 | 10 | Tantalum nitride | 60 | 0 | 40 | 0 | 3 | 65 |
| Example 4 | 58 | 28 | 14 | 10 | 3 | Tantalum oxynitride | 40 | 20 | 40 | 10 | Tantalum nitride | 60 | 0 | 40 | 0 | 3 | 65 |
| Example 5 | 42 | 58 | 0 | 10 | 3 | Tantalum oxynitride | 40 | 20 | 40 | 10 | Tantalum nitride | 60 | 0 | 40 | 0 | 3 | 65 |
| Example 6 | 42 | 58 | 0 | 10 | 2 | Tantalum oxynitride | 40 | 20 | 40 | 20 | Tantalum nitride | 60 | 0 | 40 | 0 | 3 | 65 |
| Example 7 | 42 | 58 | 0 | 10 | 1 | Tantalum oxynitride | 40 | 20 | 40 | 12 | Tantalum nitride | 60 | 0 | 40 | 0 | 3 | 65 |
| Example 8 | 42 | 58 | 0 | 2 | 8 | Tantalum oxynitride | 40 | 20 | 40 | 14 | Tantalum nitride | 60 | 0 | 40 | 0 | 3 | 65 |
| Example 9 | 42 | 58 | 0 | 12 | 2 | Tantalum oxynitride | 40 | 20 | 40 | 10 | Tantalum nitride | 60 | 0 | 40 | 0 | 3 | 65 |
| Example 10 | 42 | 58 | 0 | 10 | 3 | Tantalum oxynitride | 40 | 20 | 40 | 7 | Tantalum oxynitride | 60 | 2 | 38 | 0 | 3 | 65 |
| Example 11 | Without first layer | | | | 3 | Tantalum oxynitride | 40 | 20 | 40 | 7 | Tantalum oxynitride | 60 | 2 | 38 | 0 | 3 | 65 |
| Comparative Example 1 | 42 | 58 | 0 | 10 | Without upper hard mask layer 2A of second layer | | | | | 5 | Chromium oxide | 0 | 10 | 0 | 90 | 3 | 65 |
| Comparative Example 2 | 42 | 58 | 0 | 10 | Without upper hard mask layer 2A of second layer | | | | | 10 | Chromium oxide | 0 | 10 | 0 | 90 | 3 | 65 |
| Comparative Example 3 | Without first layer | | | | Without upper hard mask layer 2A of second layer | | | | | 5 | Chromium oxide | 0 | 10 | 0 | 90 | 3 | 65 |
| Comparative Example 4 | Without first layer | | | | Without upper hard mask layer 2A of second layer | | | | | 10 | Chromium oxide | 0 | 10 | 0 | 90 | 3 | 65 |

### Clear Time of Fluorine-Based Dry Etching of First Layer 51

The time (clear time) until the first layer 51 disappeared was measured by fluorine-based dry etching using the reflective photomask blank obtained in each of Examples 1 to 10 and Comparative Examples 1 and 2. The clear time of the fluorine-based dry etching was defined as the time until the end point detection (time until the end point) when dry etching was performed on the first layer 51 under the following conditions (condition 1). The results are shown in Table 2.

### <Conditions of Fluorine-Based Dry Etching of First Layer 51 (Condition 1)>

Apparatus: Inductively coupled plasma (ICP) method
Gas: SF₆ gas + He gas
Gas pressure: 4.0 mTorr (0.53 Pa)
ICP power: 400 W

### Clear Time of Fluorine-Based Dry Etching of Upper Hard Mask Layer 52 and Lower Hard Mask Layer 53

For the reflective photomask blank obtained in each of Examples 1 to 11, the clear time of the fluorine-based dry etching of the first layer 51 was measured, the upper hard mask layer 52 of the second layer was removed by fluorine-based dry etching, and then the time (clear time) until the lower hard mask layer 53 of the second layer disappeared was measured. The clear time of fluorine-based dry etching was defined as the time until the end point detection (time until the end point) when dry etching was performed on the upper hard mask layer 52 of the second layer and the lower hard mask layer 53 of the second layer under the following conditions (condition 2), which are the same as the above condition 1. The results are shown in Table 2.

### <Conditions of Fluorine-Based Dry Etching of Upper Hard Mask Layer 52 and Lower Hard Mask Layer 53 (Condition 2)>

Apparatus: Inductively coupled plasma (ICP) method
Gas: SF₆ gas + He gas
Gas pressure: 4.0 mTorr (0.53 Pa)
ICP power: 400 W

### <Conditions of Chlorine-Based Dry Etching Containing No Oxygen for Lower Hard Mask Layer 53 of Second Layer (Condition 3)>

For the reflective photomask blank obtained in each of Examples 1 to 11, the clear time of the fluorine-based dry etching of the first layer 51 was measured, the upper hard mask layer 52 of the second layer was removed by fluorine-based dry etching, and then the time (clear time) until the lower hard mask layer 53 of the second layer disappeared was measured. The clear time of the chlorine-based dry etching containing no oxygen was defined as the time until the end point detection (time until the end point) when dry etching was performed on the lower hard mask layer 53 of the second layer under the following conditions (condition 3). The results are shown in Table 2.

### <Conditions of Chlorine-Based Dry Etching Containing No Oxygen for Lower Hard Mask Layer 53 of Second Layer (Condition 3)>

Apparatus: Inductively coupled plasma (ICP) method
Gas: Cl₂ gas
Gas pressure: 3.0 mTorr (0.40 Pa)
ICP power: 350 W

### Clear Time of Fluorine-Based Dry Etching of Absorbing Layer 42 of Light Absorbing Film

For the reflective photomask blank obtained in each of Examples 1 to 11 and Comparative Examples 1 to 4, the clear time of the fluorine-based dry etching of the first layer 51 was measured, the clear time of the fluorine-based dry etching of the lower hard mask layer 53 of the second layer was measured, the oxide layer 41 of the light absorbing film was removed, and then, the time (clear time) until the absorbing layer 42 of the light absorbing film disappeared was measured. The clear time of the fluorine-based dry etching was defined as the time until the end point detection (time until the end point) when dry etching was performed on the absorbing layer 42 of the light absorbing film under the following conditions (condition 4), which are the same as the above condition 1. The results are shown in Table 2.

### <Conditions of Fluorine-Based Dry Etching of Oxide Layer 41 of Light Absorbing Film and Absorbing Layer 42 of Light Absorbing Film (Condition 4)>

Apparatus: Inductively coupled plasma (ICP) method
Gas: SF₆ gas + He gas
Gas pressure: 4.0 mTorr (0.53 Pa)
ICP power: 400 W

### Clear Time of Chlorine-Based Dry Etching Containing No Oxygen for Absorbing Layer 42 of Light Absorbing Film

For the reflective photomask blank obtained in each of Examples 1 to 11 and Comparative Examples 1 to 4, the clear time of the fluorine-based dry etching of the first layer 51 was measured, the clear time of the fluorine-based dry etching of the lower hard mask layer 53 of the second layer was measured, the oxide layer 41 of the light absorbing film was removed under the above condition 3, and then, the time (clear time) until the absorbing layer 42 of the light absorbing film disappeared was measured.

The clear time of the chlorine-based dry etching containing no oxygen was defined as the time until the end point detection (time until the end point) when dry etching was performed on the absorbing layer 42 of the light absorbing film under the following conditions (condition 5), which are the same as the above condition 3. The results are shown in Table 2.

### <Conditions of Chlorine-Based Dry Etching Not Containing Oxygen for Absorbing Layer 42 of Light Absorbing Film (Condition 5)>

Apparatus: Inductively coupled plasma (ICP) method
Gas: Cl₂ gas
Gas pressure: 3.0 mTorr (0.40 Pa)
ICP power: 350 W

**[Table 2]**

| | Fluorine-based dry etching of first layer | | Fluorine-based dry etching of lower hard mask layer 2B of second layer | | Chlorine-based dry etching containing no oxygen for lower hard mask layer 2B of second layer | | Fluorine-based dry etching of absorbing layer of light absorbing film | | Chlorine-based dry etching containing no oxygen for absorbing layer of light absorbing film | Fluorine-based dry etching of oxide layer of light absorbing film | | Fluorine-based dry etching of upper hard mask layer 2A of second layer | |
|---|---|---|---|---|---|---|---|---|---|---|---|---|---|
| | Clear time [sec] | Etching rate [nm/sec] | Clear time [sec] | Etching rate [nm/sec] | Clear time [sec] | Etching rate [nm/sec] | Clear time [sec] | Etching rate [nm/sec] | Etching rate [nm/sec] | Clear time [sec] | Etching rate [nm/sec] | Clear time [sec] | Etching rate [nm/sec] |
| Example 1 | 20 | 0.50 | 5 | 0.56 | 10 | 0.54 | 65 | 1.00 | 0.54 | 5 | 0.56 | 5 | 0.56 |
| Example 2 | 25 | 0.40 | 5 | 0.56 | 14 | 0.54 | 65 | 1.00 | 0.54 | 5 | 0.56 | 5 | 0.56 |
| Example 3 | 18 | 0.56 | 5 | 0.56 | 10 | 0.54 | 65 | 1.00 | 0.54 | 5 | 0.56 | 5 | 0.56 |
| Example 4 | 22 | 0.45 | 5 | 0.56 | 10 | 0.54 | 65 | 1.00 | 0.54 | 5 | 0.56 | 5 | 0.56 |
| Example 5 | 19 | 0.53 | 5 | 0.56 | 10 | 0.54 | 65 | 1.00 | 0.54 | 5 | 0.56 | 5 | 0.56 |
| Example 6 | 19 | 0.53 | 4 | 0.56 | 20 | 0.54 | 65 | 1.00 | 0.54 | 5 | 0.56 | 4 | 0.56 |
| Example 7 | 19 | 0.53 | 2 | 0.56 | 12 | 0.54 | 65 | 1.00 | 0.54 | 5 | 0.56 | 2 | 0.56 |
| Example 8 | 4 | 0.53 | 14 | 0.56 | 14 | 0.54 | 65 | 1.00 | 0.54 | 5 | 0.56 | 14 | 0.56 |
| Example 9 | 23 | 0.53 | 4 | 0.56 | 10 | 0.54 | 65 | 1.00 | 0.54 | 5 | 0.56 | 4 | 0.56 |
| Example 10 | 19 | 0.53 | 4 | 0.75 | 7 | 0.60 | 65 | 1.00 | 0.60 | 5 | 0.56 | 4 | 0.75 |
| Example 11 | Without first layer | | 5 | 0.56 | 10 | 0.60 | 65 | 1.00 | 0.60 | 5 | 0.56 | 5 | 0.56 |
| Comparative Example 1 | 19 | 0.53 | Unmeas urable | Unmeasu rable | 5 | 0.54 | 65 | 1.00 | 0.54 | 5 | 0.56 | Without upper hard mask layer 2A of second layer | |
| Comparative Example 2 | 19 | 0.53 | Unmeas urable | Unmeasu rable | 10 | 0.54 | 65 | 1.00 | 0.54 | 5 | 0.56 | Without upper hard mask layer 2A of second layer | |
| Comparative Example 3 | Without first layer | | Unmeas urable | Unmeasu rable | 5 | 0.54 | 65 | 1.00 | 0.54 | 5 | 0.56 | Without upper hard mask layer 2A of second layer | |
| Comparative Example 4 | Without first layer | | Unmeas urable | Unmeasu rable | 10 | 0.54 | 65 | 1.00 | 0.54 | 5 | 0.56 | Without upper hard mask layer 2A of second layer | |

Note that the etching clear time when 1/2 of the thickness of the absorbing layer 42 of the light absorbing film is subjected to fluorine-based dry etching is about half or half of the clear time of the absorbing layer 42 of the light absorbing film in Table 2 described above. Therefore, when the "clear time" of the absorbing layer 42 of the light absorbing film at the time of performing the fluorine-based dry etching is "65 seconds", the etching clear time at the time of performing the fluorine-based dry etching on 1/2 of the thickness of the absorbing layer 42 of the light absorbing film is about "32.5 seconds".

### Reduction Amount of Resist Film in Fluorine-Based Dry Etching of First Layer 51 and Upper Hard Mask Layer 52 of Second Layer

Using the reflective photomask blanks obtained in Examples 1 to 10, the amount (thickness) by which the resist film was reduced by fluorine-based dry etching until the first layer 51 and the upper hard mask layer 52 of the second layer disappeared was measured. First, a positive chemically amplified electron beam resist was spin-coated on the first layer 51 to form a resist film having a thickness of 60 nm. Next, a total of 20 isolated line patterns having a long side of 100,000 nm and a short side of 60 nm were lithographed at a dose of 100 µC/cm² using an electron beam lithography apparatus. Next, a heat treatment (PEB: Post Exposure Bake) was performed at 115°C for 14 minutes using a heat treatment apparatus. Next, development processing was performed for 40 seconds by paddle development to form a resist pattern. Next, using the resist pattern as an etching mask, fluorine-based dry etching was performed on the first layer 51 and the upper hard mask layer 52 of the second layer under the condition 1 described above to simultaneously form a first layer 51 pattern and an upper hard mask layer pattern of the second layer. Thereafter, a thickness of the resist pattern remaining on the first layer pattern was measured, and the reduced thickness was calculated. The results are shown in Table 3. The thickness of the resist pattern was measured using an atomic force microscope (AFM), and the measurement range was a square region of 200 nm × 200 nm (the same applies hereinafter).

In addition, using the obtained reduction amount, after etching the upper hard mask layer 52 of the second layer was performed as fluorine-based dry etching of the first layer 51 and the upper hard mask layer 52 of the second layer, the thickness of the resist film required for the resist pattern to remain with a thickness of 15 nm was calculated. The results are shown in Table 3. The thickness is the minimum required thickness of the resist film in the manufacturing of the reflective photomask using the reflective photomask blank of each of Examples 1 to 10 described below. When the thickness of the resist pattern remaining after etching is too thin, the fluorine-based plasma reaches the first layer 51 and pinhole defects are formed. Therefore, here, the thickness of the resist pattern remaining after dry etching was set to 15 nm. The results are shown in Table 3.

### Reduction Amount of Resist Film in Fluorine-Based Dry Etching of First Layer 51

Using the reflective photomask blanks obtained in Comparative Examples 1 and 2, the amount (thickness) by which the resist film was reduced by fluorine-based dry etching until the first layer 51 disappeared was measured. First, a positive chemically amplified electron beam resist was spin-coated on the first layer 51 to form a resist film having a thickness of 60 nm. Next, a total of 20 isolated line patterns having a long side of 100,000 nm and a short side of 60 nm were lithographed at a dose of 100 µC/cm² using an electron beam lithography apparatus. Next, a heat treatment (PEB: Post Exposure Bake) was performed at 115°C for 14 minutes using a heat treatment apparatus. Next, development processing was performed for 40 seconds by paddle development to form a resist pattern. Next, using the resist pattern as an etching mask, fluorine-based dry etching was performed on the first layer 51 under the condition 1 described above to form a pattern of the first layer 51. A thickness of the resist pattern remaining on the first layer pattern was measured, and the reduced thickness was calculated. The results are shown in Table 3. The thickness of the resist pattern was measured using an atomic force microscope (AFM), and the measurement range was a square region of 200 nm × 200 nm (the same applies hereinafter).

### Reduction Amount of Resist Film in Fluorine-Based Dry Etching of Upper Hard Mask Layer 52 of Second Layer

Using the reflective photomask blank obtained in Example 11, the amount (thickness) by which the resist film was reduced by fluorine-based dry etching until the upper hard mask layer 52 of the second layer disappeared was measured. First, a positive chemically amplified electron beam resist was spin-coated on the upper hard mask layer 52 of the second layer to form a resist film having a thickness of 60 nm. Next, a total of 20 isolated line patterns having a long side of 100,000 nm and a short side of 60 nm were lithographed at a dose of 100 µC/cm² using an electron beam lithography apparatus. Next, a heat treatment (PEB: Post Exposure Bake) was performed at 115°C for 14 minutes using a heat treatment apparatus. Next, development processing was performed for 40 seconds by paddle development to form a resist pattern.

Next, using the resist pattern as an etching mask, fluorine-based dry etching was performed on the upper hard mask layer 52 of the second layer under the condition 1 described above to simultaneously form an upper hard mask layer pattern of the second layer. Thereafter, a thickness of the resist pattern remaining on the upper hard mask layer pattern of the second layer was measured, and the reduced thickness was calculated. The results are shown in Table 3. The thickness of the resist pattern was measured using an atomic force microscope (AFM), and the measurement range was a square region of 200 nm × 200 nm (the same applies hereinafter).

In addition, using the obtained reduction amount, after etching the upper hard mask layer 52 of the second layer was performed as fluorine-based dry etching of the upper hard mask layer 52 of the second layer, the thickness of the resist film required for the resist pattern to remain with a thickness of 15 nm was calculated. The results are shown in Table 3. The thickness is the minimum required thickness of the resist film in the manufacturing of the reflective photomask using the reflective photomask blank of Example 11 described below. When the thickness of the resist pattern remaining after etching is too thin, the fluorine-based plasma reaches the upper hard mask layer 52 of the second layer, and pinhole defects are formed. Therefore, here, the thickness of the resist pattern remaining after dry etching was set to 15 nm. The results are shown in Table 3.

### Reduction Amount of Resist Film in Chlorine-Based Dry Etching of Hard Mask Layer of Second Layer

Using the reflective photomask blanks obtained in Comparative Examples 3 and 4, the amount (thickness) by which the resist film was reduced by chlorine-based dry etching until the hard mask layer of the second layer disappeared was measured. First, a positive chemically amplified electron beam resist was spin-coated on the second layer to form a resist film having a thickness of 60 nm. Next, a total of 20 isolated line patterns having a long side of 100,000 nm and a short side of 60 nm were lithographed at a dose of 100 µC/cm² using an electron beam lithography apparatus. Next, a heat treatment (PEB: Post Exposure Bake) was performed at 115°C for 14 minutes using a heat treatment apparatus. Next, development processing was performed for 40 seconds by paddle development to form a resist pattern. Next, using the resist pattern as an etching mask, chlorine-based dry etching was performed on the hard mask layer of the second layer under the condition 2 described above with 300% over-etching to form a pattern of the second layer. Thereafter, a thickness of the resist pattern remaining on the pattern of the second layer was measured, and the reduced thickness was calculated. The results are shown in Table 3.

In addition, using the obtained reduction amount, after performing 300% over-etching as chlorine-based dry etching of the second layer, the thickness of the resist film required for the resist pattern to remain with a thickness of 15 nm was calculated. The results are shown in Table 3. The thickness is the minimum required thickness of the resist film in the manufacturing of the reflective photomask using the reflective photomask blanks of Comparative Examples 3 and 4 described below. When the thickness of the resist pattern remaining after etching is too thin, the chlorine-based plasma reaches the second layer and pinhole defects are formed. Therefore, here, the thickness of the resist pattern remaining after dry etching was set to 15 nm.

**[Table 3]**

| | Reduction amount of resist film [nm] | Required resist film thickness [nm] |
|---|---|---|
| Example 1 | 36 | 51 |
| Example 2 | 43 | 58 |
| Example 3 | 33 | 48 |
| Example 4 | 38 | 53 |
| Example 5 | 34 | 49 |
| Example 6 | 32 | 47 |
| Example 7 | 29 | 44 |
| Example 8 | 25 | 40 |
| Example 9 | 37 | 52 |
| Example 10 | 32 | 47 |
| Example 11 | 8 | 23 |
| Comparative Example 1 | 27 | 42 |
| Comparative Example 2 | 27 | 42 |
| Comparative Example 3 | 60 | 75 |
| Comparative Example 4 | 120 | 135 |

### Examples 12 to 21

A resist film was formed on the first layer 51 of the reflective photomask blank obtained in each of Examples 1 to 10 by spin-coating a positive chemically amplified electron beam resist to obtain a reflective photomask blank (reflective photomask blank of the second aspect) having a resist film as illustrated in FIG. 2. The thickness of the resist film was set to a thickness at which a resist pattern having a thickness of 15 nm remained after the fluorine-based dry etching described above, and to a thickness of 40 nm or more which is the lower limit of the thickness at which the resist film was formed at a stable thickness using the used resist material. The thickness of the resist film is shown in Table 4.

In order to evaluate the resolution limit of the fine pattern corresponding to the assist pattern of the isolated line pattern, a reflective photomask was manufactured using a reflective photomask blank having the obtained resist film. First, as a test pattern corresponding to an assist pattern of a line pattern at a dose of 100 µC/cm², a total of 200,000 isolated patterns having different short side dimensions, in which the long side dimension was 80 nm and the short side dimension was changed from 10 nm to 60 nm by 1 nm, were written using an electron beam lithography apparatus. Next, a heat treatment (PEB: Post Exposure Bake) was performed at 110°C for 14 minutes using a heat treatment apparatus. Next, development processing was performed for 40 seconds by paddle development to form a resist pattern. Next, using the obtained resist pattern as an etching mask, fluorine-based dry etching was performed on the first layer 51 and the upper hard mask layer 52 of the second layer under the condition 1 described above to form a first layer pattern and an upper hard mask layer pattern of the second layer. Next, the remaining resist pattern was removed by cleaning with sulfuric acid hydrogen peroxide (a mixed solution of sulfuric acid : aqueous hydrogen peroxide = 3:1)). Next, using the first layer pattern and the upper hard mask layer pattern of the second layer as an etching mask, the lower hard mask layer 53 of the second layer was subjected to 100% over-etching using chlorine-based dry etching containing no oxygen under the condition 3 described above to form a lower hard mask layer pattern of the second layer.

Next, using the first layer pattern, the upper hard mask layer pattern of the second layer, and the lower hard mask layer pattern of the second layer as hard masks, fluorine-based dry etching was performed on the oxide layer 41 of the light absorbing film under the condition 4 described above to form an oxide layer 41 pattern of the light absorbing film and parts of an absorbing layer pattern of the light absorbing film and simultaneously to remove a first layer pattern, an upper hard mask layer pattern of the second layer, and parts of a lower hard mask layer pattern of the second layer.

Next, using the lower hard mask layer pattern of the second layer and the oxide layer 41 pattern of the light absorbing film as etching masks, the light absorbing pattern of the light absorbing film remaining in the above step was dry-etched using chlorine-based gas containing no oxygen to form an absorbing layer pattern of the light absorbing film, and at the same time, the lower hard mask layer 53 of the second layer was removed to obtain a reflective photomask.

Next, a resolution limit of the test pattern of the obtained photomask was evaluated using a mask appearance inspection apparatus. For all the isolated patterns, pattern disappearance, pattern collapse, and pattern shape defect were evaluated, the isolated pattern in which any of pattern disappearance, pattern collapse, and pattern shape defect was detected by the appearance inspection apparatus was defined as a defect, and the minimum short-side dimension without the isolated pattern in which the defect was detected was defined as a resolution limit. In addition, a thickness of the protective film of the reflective photomask obtained in the above mask manufacturing step was measured using an X-ray diffractometer, and the thickness of the protective film that disappeared during the above mask step was evaluated. Thereafter, the results are shown in Table 4.

### Example 22

A resist film was formed on the upper hard mask layer 52 of the second layer of the reflective photomask blank obtained in Example 11 by spin-coating a positive chemically amplified electron beam resist to obtain a reflective photomask blank (reflective photomask blank of the second aspect) having a resist film as illustrated in FIG. 2. The thickness of the resist film was set to a thickness at which a resist pattern having a thickness of 15 nm remained after the fluorine-based dry etching described above, and to a thickness of 40 nm or more which is the lower limit of the thickness at which the resist film was formed at a stable thickness using the used resist material. The thickness of the resist film is shown in Table 4.

In order to evaluate the resolution limit of the fine pattern corresponding to the assist pattern of the isolated line pattern, a reflective photomask was manufactured using a reflective photomask blank having the obtained resist film. First, as a test pattern corresponding to an assist pattern of a line pattern at a dose of 100 µC/cm², a total of 200,000 isolated patterns having different short side dimensions, in which the long side dimension was 80 nm and the short side dimension was changed from 10 nm to 60 nm by 1 nm, were written using an electron beam lithography apparatus. Next, a heat treatment (PEB: Post Exposure Bake) was performed at 110°C for 14 minutes using a heat treatment apparatus. Next, development processing was performed for 40 seconds by paddle development to form a resist pattern. Next, using the obtained resist pattern as an etching mask, fluorine-based dry etching was performed on the upper hard mask layer 52 of the second layer under the condition 1 described above to form an upper hard mask layer pattern of the second layer. Next, the remaining resist pattern was removed by cleaning with sulfuric acid hydrogen peroxide (a mixed solution of sulfuric acid : aqueous hydrogen peroxide = 3:1)). Next, using the upper hard mask layer pattern of the second layer as an etching mask, the lower hard mask layer 53 of the second layer was subjected to 100% over-etching using chlorine-based dry etching containing no oxygen under the condition 3 described above to form a lower hard mask layer pattern of the second layer.

Next, using the upper hard mask layer pattern of the second layer and the lower hard mask layer pattern of the second layer as hard masks, fluorine-based dry etching was performed on the oxide layer 41 of the light absorbing film under the condition 4 described above to form an oxide layer 41 pattern of the light absorbing film and to partially form an absorbing layer pattern of the light absorbing film and simultaneously to remove an upper hard mask layer pattern of the second layer and to partially remove a lower hard mask layer pattern of the second layer.

Next, using the lower hard mask layer pattern of the second layer and the oxide layer 41 pattern of the light absorbing film as etching masks, the light absorbing pattern of the light absorbing film remaining in the above step was dry-etched using chlorine-based gas containing no oxygen to form an absorbing layer pattern of the light absorbing film, and at the same time, the lower hard mask layer 53 of the second layer was removed to obtain a reflective photomask.

Next, a resolution limit of the test pattern of the obtained photomask was evaluated using a mask appearance inspection apparatus. For all the isolated patterns, pattern disappearance, pattern collapse, and pattern shape defect were evaluated, the isolated pattern in which any of pattern disappearance, pattern collapse, and pattern shape defect was detected by the appearance inspection apparatus was defined as a defect, and the minimum short-side dimension without the isolated pattern in which the defect was detected was defined as a resolution limit. In addition, a thickness of the protective film of the reflective photomask obtained in the above mask manufacturing step was measured using an X-ray diffractometer, and the thickness of the protective film that disappeared during the above mask step was evaluated. Thereafter, the results are shown in Table 4.

### Comparative Examples 5 and 6

A resist film was formed on the hard mask layer (the second layer) of the reflective photomask blank obtained in each of Comparative Examples 1 and 2 by spin-coating a positive chemically amplified electron beam resist to obtain a reflective photomask blank (reflective photomask blank of the second aspect) having a resist film as illustrated in FIG. 2. The thickness of the resist film was set to a thickness at which a resist pattern having a thickness of 15 nm remained after the fluorine-based dry etching described above, and to a thickness of 40 nm or more which is the lower limit of the thickness at which the resist film was formed at a stable thickness using the used resist material. The thickness of the resist film is shown in Table 4.

In order to evaluate the resolution limit of the fine pattern corresponding to the assist pattern of the isolated line pattern, a reflective photomask was manufactured using a reflective photomask blank having the obtained resist film. First, as a test pattern corresponding to an assist pattern of a line pattern at a dose of 100 µC/cm², a total of 200,000 isolated patterns having different short side dimensions, in which the long side dimension was 80 nm and the short side dimension was changed from 10 nm to 60 nm by 1 nm, were written using an electron beam lithography apparatus. Next, a heat treatment (PEB: Post Exposure Bake) was performed at 110°C for 14 minutes using a heat treatment apparatus. Next, development processing was performed for 40 seconds by paddle development to form a resist pattern. Next, using the obtained resist pattern as an etching mask, fluorine-based dry etching was performed on the first layer 51 under the condition 1 described above to form a first layer pattern. Next, the remaining resist pattern was removed by cleaning with sulfuric acid hydrogen peroxide (a mixed solution of sulfuric acid : aqueous hydrogen peroxide = 3:1)). Next, using the first layer pattern as an etching mask, the hard mask layer of the second layer (chromium-based film) was subjected to 300% over-etching using chlorine-based dry etching containing oxygen under the following condition 6 to form a hard mask layer pattern of the second layer.

### <Conditions of Chlorine-Based Dry Etching Containing Oxygen for Hard Mask Layer of Second Layer (Condition 6)>

Apparatus: Inductively coupled plasma (ICP) method
Gas: Cl₂ gas + O₂ gas
Gas pressure: 3.0 mTorr (0.40 Pa)
ICP power: 350 W

Next, using the first layer pattern and the hard mask layer of the second layer (chromium-based film) as etching masks, fluorine-based dry etching was performed on the oxide layer 41 of the light absorbing film under the condition 3 described above to form an oxide layer 41 pattern of the light absorbing film and to partially form a light absorbing film pattern and simultaneously to remove the first layer pattern.

Next, using the hard mask layer of the second layer (chromium-based film) as an etching mask, the light absorbing pattern of the light absorbing film remaining in the above step was dry-etched using chlorine-based gas containing no oxygen to form an absorbing layer pattern of the light absorbing film.

Next, dry etching using chlorine-based gas containing oxygen was performed to remove the hard mask layer (chromium-based film) pattern of the second layer, thereby obtaining a reflective photomask.

Next, a resolution limit of the test pattern of the obtained photomask was evaluated using a mask appearance inspection apparatus. For all the isolated patterns, pattern disappearance, pattern collapse, and pattern shape defect were evaluated, the isolated pattern in which any of pattern disappearance, pattern collapse, and pattern shape defect was detected by the appearance inspection apparatus was defined as a defect, and the minimum short-side dimension without the isolated pattern in which the defect was detected was defined as a resolution limit. In addition, a thickness of the protective film of the reflective photomask obtained in the above mask manufacturing step was measured using an X-ray diffractometer, and the thickness of the protective film that disappeared during the above mask step was evaluated. The results are shown in Table 4.

### Comparative Examples 7 and 8

On the hard mask layer (chromium-based film) of the reflective photomask blank obtained in each of Comparative Examples 3 and 4, a positive chemically amplified electron beam resist was spin-coated to form a resist film, thereby obtaining a reflective photomask blank having a resist film. The thickness of the resist film was set to a thickness at which a resist pattern having a thickness of 15 nm remained after the fluorine-based dry etching described above, and to a thickness of 40 nm or more which is the lower limit of the thickness at which the resist film was formed at a stable thickness using the used resist material. The thickness of the resist film is shown in Table 4.

In order to evaluate the resolution limit of the fine pattern corresponding to the assist pattern of the isolated line pattern, a reflective photomask was manufactured using a reflective photomask blank having the obtained resist film.

In order to evaluate the resolution limit of the fine pattern corresponding to the assist pattern of the isolated line pattern, a reflective photomask was manufactured using a reflective photomask blank having the obtained resist film. First, as a test pattern corresponding to an assist pattern of a line pattern at a dose of 100 µC/cm², a total of 200,000 isolated patterns having different short side dimensions, in which the long side dimension was 80 nm and the short side dimension was changed from 10 nm to 60 nm by 1 nm, were written using an electron beam lithography apparatus. Next, a heat treatment (PEB: Post Exposure Bake) was performed at 110°C for 14 minutes using a heat treatment apparatus. Next, development processing was performed for 40 seconds by paddle development to form a resist pattern. Next, using the obtained resist pattern as an etching mask, chlorine-based dry etching containing oxygen was performed on the hard mask layer (chromium-based film) under the condition 6 described above to form a hard mask layer pattern.

Next, the remaining resist pattern was removed by cleaning with sulfuric acid hydrogen peroxide (a mixed solution of sulfuric acid : aqueous hydrogen peroxide = 3:1)).

Next, using the hard mask layer (chromium-based film) pattern as an etching mask, fluorine-based dry etching was performed on the oxide layer 41 of the light absorbing film under the condition 3 described above to form an oxide layer 41 pattern of the light absorbing film and to partially form a light absorbing film pattern.

Next, using the hard mask layer (chromium-based film) pattern and the oxide layer 41 pattern of the light absorbing film as etching masks, the light absorbing pattern of the light absorbing film remaining in the above step was dry-etched using chlorine-based gas containing no oxygen to form an absorbing layer pattern of the light absorbing film.

Next, dry etching using chlorine-based gas containing oxygen was performed to remove the hard mask layer (chromium-based film) pattern, thereby obtaining a reflective photomask.

Next, a resolution limit of the test pattern of the obtained photomask was evaluated using a mask appearance inspection apparatus. For all the isolated patterns, pattern disappearance, pattern collapse, and pattern shape defect were evaluated, the isolated pattern in which any of pattern disappearance, pattern collapse, and pattern shape defect was detected by the appearance inspection apparatus was defined as a defect, and the minimum short-side dimension without the isolated pattern in which the defect was detected was defined as a resolution limit. In addition, a thickness of the protective film of the reflective photomask obtained in the above mask manufacturing step was measured using an X-ray diffractometer, and the thickness of the protective film that disappeared during the above mask step was evaluated. The results are shown in Table 4.

**[Table 4]**

| | Reflective photomask blank | Thickness of resist film [nm] | Resolution limit [nm] | Thickness of protective film of reflective photomask [nm] | Thickness of protective film that disappeared [nm] |
|---|---|---|---|---|---|
| Example 12 | Example 1 | 51 | 18 | 4 | 1 |
| Example 13 | Example 2 | 58 | 20 | 4 | 1 |
| Example 14 | Example 3 | 48 | 18 | 4 | 1 |
| Example 15 | Example 4 | 53 | 19 | 4 | 1 |
| Example 16 | Example 5 | 49 | 18 | 4 | 1 |
| Example 17 | Example 6 | 47 | 17 | 4 | 1 |
| Example 18 | Example 7 | 44 | 17 | 4 | 1 |
| Example 19 | Example 8 | 40 | 16 | 4 | 1 |
| Example 20 | Example 9 | 52 | 19 | 4 | 1 |
| Example 21 | Example 10 | 47 | 17 | 4 | 1 |
| Example 22 | Example 11 | 40 | 20 | 4 | 1 |
| Comparative Example 5 | Comparative Example 1 | 40 | 32 | 1 | 4 |
| Comparative Example 6 | Comparative Example 2 | 40 | 40 | 1 | 4 |
| Comparative Example 7 | Comparative Example 3 | 75 | 60 | 1 | 4 |
| Comparative Example 8 | Comparative Example 4 | 135 | 75 | 1 | 4 |

As shown in Table 4, in the hard mask of the reflective photomask blank of each of Examples 1 to 10, the side farthest from the substrate was the first layer 51 formed of the material removable by fluorine-based dry etching, and in the hard mask of the reflective photomask blank of Example 11, the side farthest from the substrate was the upper hard mask layer 52 formed of the material removable by fluorine-based dry etching. In the reflective photomask blank of each of Examples 1 to 11, it was confirmed that the resist film was thin as compared with the reflective photomask blanks of Comparative Examples 3 and 4, and a particularly preferred resolution limit was obtained. This is considered to be because, since the resist film is thin, even in a pattern having a narrow line width, the resist pattern is reduced from falling due to an impact by a developer or an impact by pure water during a rinsing process in a development process of resist pattern formation.

In addition, it was confirmed that particularly excellent resolution was obtained in the reflective photomask blank of each of Examples 1 to 10 in which a film formed of a material removable by chlorine-based dry etching containing no oxygen was used under the first layer 51 of the reflective photomask blank of each of Examples 1 to 11 as compared with the reflective photomask blanks of Comparative Examples 1 and 2. This is considered to be because the upper hard mask layer 52 of the second layer and the hard mask layer of the second layer are removed by chlorine-based dry etching containing no oxygen, such that large side etching is not generated, and pattern disappearance during etching is reduced.

In addition, in the reflective photomask blank of each of Examples 1 to 11, it was confirmed that a particularly large amount of the protective film remained after the reflective photomask was manufactured compared to the reflective photomask blanks of Comparative Examples 1 to 4. This is considered to be because, since the upper hard mask layer 52 of the second layer and the hard mask layer of the second layer are used by chlorine-based dry etching containing no oxygen, it is possible to perform patterning by chlorine-based dry etching containing no oxygen when forming the absorbing layer pattern of the light absorbing film, and the protective film is not greatly damaged.

Note that the present invention is not limited to the above embodiments. The embodiments are examples, and any structure having the same or substantially the same structure as the technical idea of the present invention and exhibiting the same or similar effects is included in the technical scope of the present invention.

### Reference Signs List

- 1: Substrate
- 2: Multilayer reflective film
- 3: Protective film
- 4: Light absorbing film
- 41a: Oxide layer pattern of light absorbing film
- 42a: Absorbing layer pattern of light absorbing film
- 51: First layer
- 52: Upper hard mask layer of second layer
- 53: Lower hard mask layer of second layer
- 51a: First layer pattern
- 52: Upper hard mask layer pattern of second layer
- 53: Lower hard mask layer pattern of second layer
- 100: Reflective photomask blank
- 200: Reflective photomask

## Claims

1. A reflective photomask blank comprising:
a substrate;
a multilayer reflective film formed on the substrate and reflecting exposure light that is extreme ultraviolet region light;
a protective film formed on the multilayer reflective film and protecting the multilayer reflective film;
a light absorbing film formed on the protective film and absorbing the exposure light; and
a hard mask film provided on the light absorbing film,
wherein the light absorbing film includes a multilayer including an absorbing layer and an oxide layer containing oxygen and provided on a side that is spaced from the substrate,
wherein the oxide layer of the light absorbing film is formed of a material that has resistance to chlorine-based dry etching and is removable by fluorine-based dry etching,
wherein the absorbing layer of the light absorbing film is formed of a material that has resistance to chlorine-based dry etching containing oxygen and is removable by chlorine-based dry etching containing no oxygen and fluorine-based dry etching,
wherein the hard mask film includes a second layer or a multilayer film including a second layer and a first layer formed on a side of the second layer that is spaced from the substrate,
wherein in a case where the first layer is included, the first layer is formed of a material that has resistance to chlorine-based dry etching and is removable by fluorine-based dry etching,
wherein the second layer includes a multilayer including an upper hard mask layer provided on a side that is spaced from the substrate and containing oxygen, and a lower hard mask layer of the second layer,
wherein the upper hard mask layer of the second layer is formed of a material that has resistance to chlorine-based dry etching and is removable by fluorine-based dry etching,
wherein the lower hard mask layer of the second layer is formed of a material that has resistance to chlorine-based dry etching containing oxygen and is removable by chlorine-based dry etching containing no oxygen and fluorine-based dry etching,
wherein in a case where the first layer is not included, etching clear time when the upper hard mask layer of the second layer is subjected to fluorine-based dry etching under one condition is shorter than etching clear time when 1/2 of a thickness of the absorbing layer of the light absorbing film is subjected to the fluorine-based dry etching under the one condition, and
wherein in a case where the first layer is included, a total of etching clear time when the first layer is subjected to fluorine-based dry etching under one condition and etching clear time when the upper hard mask layer of the second layer is subjected to the fluorine-based dry etching under the one condition is shorter than a total of etching clear time when the oxide layer of the light absorbing film is subjected to the fluorine-based dry etching under the one condition and the etching clear time when 1/2 of the thickness of the absorbing layer of the light absorbing film is subjected to the fluorine-based dry etching under the one condition.

2. The reflective photomask blank according to claim 1,
wherein the hard mask film includes the first layer, and
wherein when the absorbing layer of the light absorbing film and the first layer are subjected to the fluorine-based dry etching under the one condition, a ratio of an etching rate of the first layer to an etching rate of the absorbing layer of the light absorbing film is 0.4 or more and 2.0 or less.

3. The reflective photomask blank according to claim 1 or 2,
wherein when the absorbing layer of the light absorbing film and the lower hard mask layer of the second layer are subjected to the fluorine-based dry etching under the one condition, a ratio of an etching rate of the lower hard mask layer of the second layer to an etching rate of the absorbing layer of the light absorbing film is 0.7 or more and 1.3 or less.

4. The reflective photomask blank according to any one of claims 1 to 3,
wherein when the absorbing layer of the light absorbing film and the lower hard mask layer of the second layer are subjected to chlorine-based dry etching containing no oxygen under one condition, a ratio of an etching rate of the lower hard mask layer of the second layer to an etching rate of the absorbing layer of the light absorbing film is 0.7 or more and particularly 0.8 or more and 1.3 or less.

5. The reflective photomask blank according to any one of claims 1 to 4,
wherein the hard mask film includes the first layer, and
wherein the first layer is formed of a material containing silicon but no chromium.

6. The reflective photomask blank according to any one of claims 1 to 5,
wherein the upper hard mask layer of the second layer and the lower hard mask layer of the second layer are formed of a material containing tantalum.

7. The reflective photomask blank according to any one of claims 1 to 6,
wherein the hard mask film includes the first layer, and
wherein a thickness of the first layer is 2 nm or more and 12 nm or less.

8. The reflective photomask blank according to any one of claims 1 to 7,
wherein a total thickness of the upper hard mask layer of the second layer and the lower hard mask layer of the second layer is 8 nm or more and 30 nm or less.

9. The reflective photomask blank according to any one of claims 1 to 8,
wherein the hard mask film includes the first layer, and
wherein a difference between a thickness of the first layer, and a total thickness of the oxide layer of the light absorbing film and the absorbing layer of the light absorbing film is 30 nm or more.

10. The reflective photomask blank according to any one of claims 1 to 9,
wherein the oxide layer of the light absorbing film and the absorbing layer of the light absorbing film are formed of a material containing tantalum.

11. A method for manufacturing, from the reflective photomask blank according to any one of claims 1 to 10, a reflective photomask including an oxide layer pattern of the light absorbing film and an absorbing layer pattern of the light absorbing film, the method comprising:
(A) forming a resist film in contact with a side of the first layer that is spaced from the substrate;
(B) patterning the resist film to form a resist pattern;
(C) using the resist pattern as an etching mask, simultaneously patterning the first layer and the upper hard mask layer of the second layer by dry etching using fluorine-based gas to simultaneously form a first layer pattern and an upper hard mask layer pattern of the second layer;
(D) removing the resist pattern;
(E) using the first layer pattern and the upper hard mask layer pattern of the second layer as etching masks, patterning the lower hard mask layer of the second layer by dry etching using chlorine-based gas containing no oxygen to form a lower hard mask layer pattern of the second layer;
(F) using the first layer pattern, the upper hard mask layer pattern of the second layer, and the lower hard mask layer pattern of the second layer as etching masks, patterning the oxide layer of the light absorbing film and partially patterning the absorbing layer of the light absorbing film by dry etching using fluorine-based gas to form the oxide layer pattern of the light absorbing film and to partially form the absorbing layer pattern of the light absorbing film, and simultaneously to remove the first layer pattern and the upper hard mask layer pattern of the second layer and to partially remove the lower hard mask layer pattern of the second layer; and
(G) using remaining parts of the lower hard mask layer pattern of the second layer as an etching mask, patterning the absorbing layer of the light absorbing film by dry etching using chlorine-based gas containing no oxygen, and partially removing the lower hard mask layer pattern of the second layer, simultaneously.

12. The method for manufacturing according to claim 11,
wherein a thickness of the resist film is 70 nm or less.

13. The method for manufacturing according to claim 11 or 2,
wherein the pattern of the light absorbing film includes a line pattern having a width of 20 nm or less.
